(19) Europäisches Patentamt
European Patent Office
Office européen des brevets

(11) EP 4 668 020 A1

(12) **EUROPEAN PATENT APPLICATION**
published in accordance with Art. 153(4) EPC

(43) Date of publication:
**24.12.2025 Bulletin 2025/52**

(21) Application number: **25755282.8**

(22) Date of filing: **17.02.2025**

(51) International Patent Classification (IPC):
***G03F 7/075*** (2006.01) ***C08F 287/00*** (2006.01)
***C08F 2/44*** (2006.01) ***C08F 2/50*** (2006.01)
***C08G 77/42*** (2006.01) ***C08G 77/38*** (2006.01)
***C08G 77/12*** (2006.01) ***C08K 5/3417*** (2006.01)
***C08K 5/55*** (2006.01) ***G03F 7/105*** (2006.01)

(52) Cooperative Patent Classification (CPC):
**C08F 2/44; C08F 2/50; C08F 287/00; C08G 77/12; C08G 77/38; C08G 77/42; C08K 5/3417; C08K 5/55; G03F 7/075; G03F 7/105**

(86) International application number:
**PCT/KR2025/002235**

(87) International publication number:
**WO 2025/174139 (21.08.2025 Gazette 2025/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.02.2024 KR 20240022502**
**16.02.2024 KR 20240022503**
**16.02.2024 KR 20240022504**
**14.02.2025 KR 20250019407**

(71) Applicant: **LG Chem, Ltd.**
**Seoul 07336 (KR)**

(72) Inventors:
- **HEO, Yongjoon**
**Daejeon 34122 (KR)**
- **CHOI, Hang Seok**
**Daejeon 34122 (KR)**
- **LEE, Hanna**
**Daejeon 34122 (KR)**
- **MOON, Sang Pil**
**Daejeon 34122 (KR)**
- **KIM, Min Soo**
**Daejeon 34122 (KR)**
- **YI, Yeonhui**
**Daejeon 34122 (KR)**
- **JUNG, Soonhwa**
**Daejeon 34122 (KR)**
- **HONG, Chulsuk**
**Daejeon 34122 (KR)**

(74) Representative: **Plasseraud IP**
**104 Rue de Richelieu**
**CS92104**
**75080 Paris Cedex 02 (FR)**

# (54) PHOTOPOLYMER COMPOSITION, HOLOGRAM RECORDING MEDIUM, METHOD FOR PREPARING SAME, AND OPTICAL ELEMENT COMPRISING SAME

(57) The present disclosure relates to a photopolymer composition, a hologram recording medium, a preparation method thereof, and an optical element comprising the same. The photopolymer composition is able to provide a hologram recording medium and an optical element comprising the same, which exhibit excellent optical recording characteristics such as diffraction efficiency, while securing colorless and transparent optical properties along with superior thermal stability.

EP 4 668 020 A1

【FIG. 1】

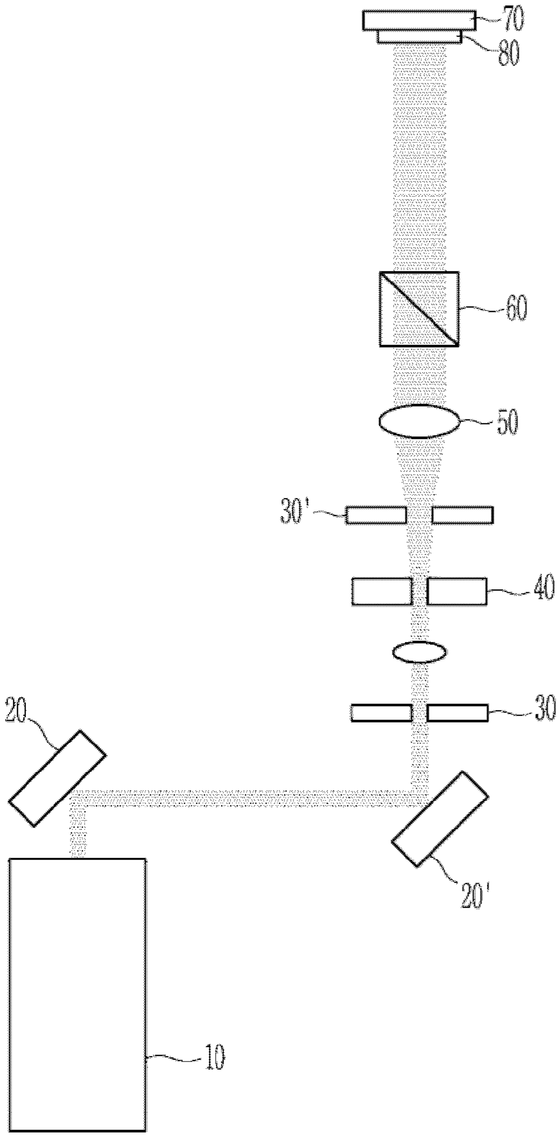

## Description

### [TECHNICAL FIELD]

Cross-reference to Related Application(s)

This application claims the benefit of Korean Patent Application No. 10-2024-0022502 filed on February 16, 2024, Korean Patent Application No. 10-2024-0022503 filed on February 16, 2024, Korean Patent Application No. 10-2024-0022504 filed on February 16, 2024, and Korean Patent Application No. 10-2025-0019407 filed on February 14, 2025 in the Korean Intellectual Property Office, the disclosures of which are incorporated herein by reference in their entirety.

The present disclosure relates to a photopolymer composition, a hologram recording medium, a preparation method thereof, and an optical element comprising the same.

### [BACKGROUND OF ART]

Hologram recording medium records information by changing a refractive index in the holographic recording layer in the medium through an exposure process, reads the variation of refractive index in the medium thus recorded, and reproduces the information.

In this regard, a photopolymer composition can be used for preparing a hologram. The photopolymer can easily store light interference pattern as a hologram by photopolymerization of a photoreactive monomer. Therefore, the photopolymer can be used in various fields such as, for example, smart devices such as mobile devices, wearable display parts, vehicle articles (e.g., head up display), holographic fingerprint recognition system, optical lenses, mirrors, deflecting mirrors, filters, diffusing screens, diffraction elements, light guides, waveguides, holographic optical elements having projection screen and/or mask functions, medium of optical memory system and light diffusion plate, optical wavelength multiplexers, reflection type, transmission type color filters, and the like.

Specifically, a photopolymer composition for preparing a hologram includes a polymer matrix, a photoreactive monomer, and a photoinitiator system, and the photopolymer layer prepared from such a composition is irradiated with laser interference light to induce photopolymerization of local monomers.

A refractive index modulation is generated through this local photopolymerization process, and a diffraction grating is generated by such a refractive index modulation. The refractive index modulation value ($\triangle n$) is influenced by the thickness and the diffraction efficiency (DE) of the photopolymer layer, and the angular selectivity increases as the thickness decreases.

Recently, a request for development of materials capable of maintaining a stable hologram with a high diffraction efficiency has been increased, and also various attempts have been made to prepare a hologram recording medium having high diffraction efficiency and high refractive index modulation values as well as a thin thickness.

### [DETAILED DESCRIPTION OF THE INVENTION]

### [Technical Problem]

According to an embodiment of the present disclosure, a photopolymer composition is provided.

According to another embodiment of the present disclosure, a photopolymer composition is provided.

According to yet another embodiment of the present disclosure, a hologram recording medium is provided.

According to a further embodiment of the present disclosure, a method for preparing the hologram recording medium is provided.

According to a further embodiment of the present disclosure, an optical element comprising the hologram recording medium is provided.

### [Technical Solution]

Hereinafter, a photopolymer composition, a hologram recording medium, a preparation method thereof, an optical element comprising the same, and the like according to specific embodiments of the present disclosure will be described.

The term "hologram recording medium" as used herein means a medium (or media) on which optical information can be recorded in an entire visible range and an ultraviolet range (e.g., 300 to 1,200 nm) through an exposure process, unless specifically stated otherwise. The hologram herein may include all of visual holograms such as in-line (Gabor) holograms, off-axis holograms, full-aperture transfer holograms, white light transmission holograms ("rainbow holograms"), Denisyuk holograms, off-axis reflection holograms, edge-literature holograms or holographic stereograms.

In this specification, in relation to environmental conditions, etc. under which a hologram recording medium or a device including the same is placed, "high temperature" may mean a temperature of 60°C or more. For example, the high temperature may mean a temperature of 65°C or more, 70°C or more, 75°C or more, 80°C or more, 85°C or more, or 90°C or more, and the upper limit thereof is not particularly limited, but may be, for example, 110°C or less, 105°C or less, 100°C or less, 95°C or less, 90°C or less, 85°C or less, or 80°C or less. When temperature affects the characteristics of a material, object, or component, unless temperature is specifically mentioned otherwise, the temperature condition under which the characteristic is measured or explained may mean a room temperature (e.g., a temperature in the range of about 15 to 30°C which is a temperature without heating or cooling).

In this specification, unless otherwise stated, the measured values are understood to be those of a photopolymer layer comprised in a hologram recording medium.

According to one embodiment of the disclosure, there is provided a photopolymer composition comprising: a polymer matrix or a precursor thereof; a photoreactive monomer; a photosensitizing dye; and a co-initiator, wherein the photosensitizing dye is a compound that includes a core represented by the following Chemical Formula 1, and has an openness of 7.0 to 8.5 $Å^2$ for the double bond connecting two hetero rings.

[Chemical Formula 1]

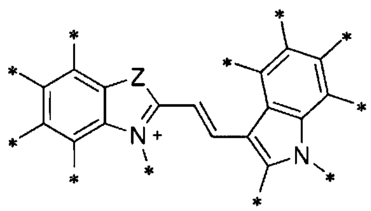

in Chemical Formula 1,

Z is oxygen, sulfur, or $CR^7R^8$
$R^7$ and $R^8$ are each independently an alkyl group having 1 to 6 carbon atoms.

In order to utilize a hologram recording medium in a variety of applications, it must be capable of optical recording in the red, green, and blue regions. However, photosensitizing dyes for optical recording in the blue region that have been developed thus far exhibit inferior optical recording properties compared to those for the red and green regions, and in particular, tend to have poor thermal stability, making them unsuitable for hologram recording media that may be exposed to high-temperature environments.

The present inventors have found through experiments that when a compound including the core represented by Chemical Formula 1 and having an openness of 7.0 to 8.5 $Å^2$ for the double bond connecting two hetero rings is used as a photosensitizing dye, it is possible to enable optical recording in the blue region and to provide a hologram recording medium with excellent optical recording characteristics and thermal stability by confirming the openness of the particular double bond comprised in the core, and completed the present invention.

A photopolymer composition, a hologram recording medium formed from the photopolymer composition, a preparation method thereof, an optical element comprising the hologram recording medium, and the like according to one embodiment of the present disclosure will be described below.

The photopolymer composition according to one embodiment of the disclosure includes a polymer matrix or a precursor thereof that serves as a support for the photopolymer layer formed therefrom.

The polymer matrix is formed by crosslinking a siloxane-based polymer containing a silane functional group (Si-H) and an acrylic-based polyol. Specifically, the polymer matrix is formed by crosslinking an acrylic-based polyol with a siloxane-based polymer containing a silane functional group. More specifically, the hydroxy group of the acrylic-based polyol can form a crosslink with the silane functional group of the siloxane-based polymer through a hydrosilylation reaction. The hydrosilylation reaction can proceed rapidly under a Pt-based catalyst even at room temperature (e.g., a temperature in the range of about 15 to 30°C which is a temperature without heating or cooling). Therefore, the hologram recording medium according to one embodiment of the disclosure employs a polymer matrix that can be quickly crosslinked even at room temperature as a support, thereby being able to improve the preparation efficiency and productivity.

The polymer matrix can enhance the mobility of components (e.g., photoreactive monomer or plasticizer, etc.) contained in the photopolymer layer due to the flexible main chain of the siloxane-based polymer. In addition, siloxane bonding having excellent heat resistance and moist heat resistance properties can facilitate ensuring reliability of the

photopolymer layer in which optical information is recorded, and of the hologram recording medium including the same.

The polymer matrix may have a relatively low refractive index, which can serve to enhance the refractive index modulation of the layer formed from the photopolymer composition. For example, the upper limit of the refractive index of the polymer matrix may be 1.53 or less, 1.52 or less, 1.51 or less, 1.50 or less, or 1.49 or less. And, the lower limit of the refractive index of the polymer matrix may be, for example, 1.40 or more, 1.41 or more, 1.42 or more, 1.43 or more, 1.44 or more, 1.45 or more, or 1.46 or more. As used herein, "refractive index" may be a value measured with an Abbe refractometer at 25°C.

The photopolymer composition according to one embodiment of the disclosure may include the polymer matrix in crosslinked form as described above, or may include a precursor thereof. When the photopolymer composition includes a precursor of the polymer matrix, it may include a siloxane-based polymer, an acrylic-based polyol, and a Pt-based catalyst.

The siloxane-based polymer may include, for example, a repeating unit represented by the following Chemical Formula 2 and a terminal end group represented by the following Chemical Formula 3.

[Chemical Formula 2]

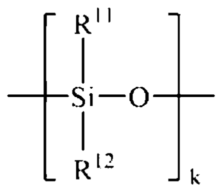

in Chemical Formula 2,

a plurality of $R^{11}$ and $R^{12}$ are the same or different from each other, and are each independently hydrogen, halogen, or an alkyl group having 1 to 10 carbon atoms, and
k is an integer of 1 to 10,000,

[Chemical Formula 3]

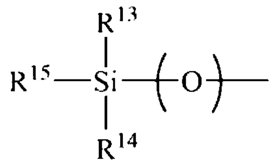

in Chemical Formula 3,

a plurality of $R^{13}$ to $R^{15}$ are the same or different from each other, and are each independently hydrogen, halogen, or an alkyl group having 1 to 10 carbon atoms, and
at least one of $R^{11}$ to $R^{15}$ of at least one repeating unit selected among the repeating units represented by Chemical Formula 2 and any one terminal end group selected among the terminal end groups represented by Chemical Formula 3 is hydrogen.

In Chemical Formula 3, -(O)- means either bonding through oxygen (O) or directly bonding without oxygen (O) when Si of the terminal end group represented by Chemical Formula 3 is bonded to the repeating unit represented by Chemical Formula 2.

As used herein, "alkyl group" may be a straight chain, branched chain, or cyclic alkyl group. By way of non-limiting example, "alkyl group" as used herein may be methyl, ethyl, propyl (e.g. n-propyl, isopropyl, etc.), butyl (e.g., n-butyl, isobutyl, tert-butyl, sec-butyl, cyclobutyl, etc.), pentyl (e.g., n-pentyl, isopentyl, neopentyl, tert-pentyl, 1,1-dimethyl-propyl, 1-ethyl-propyl, 1-methyl-butyl, cyclopentyl, etc.), hexyl (e.g., n-hexyl, 1-methylpentyl, 2-methylpentyl, 4-methylpentyl, 3,3-dimethylbutyl, 1-ethyl-butyl, 2-ethylbutyl, cyclopentylmethyl, cyclohexyl, etc.), heptyl (e.g., n-heptyl, 1-methylhexyl, 4-methylhexyl, 5-methylhexyl, cyclohexylmethyl, etc.), octyl (e.g., n-octyl, tert-octyl, 1-methylheptyl, 2-ethylhexyl, 2-propylpentyl, etc.), nonyl (e.g., n-nonyl, 2,2-dimethylheptyl, etc.), and the like.

In one example, $R^{11}$ to $R^{15}$ in Chemical Formulas 2 and 3 are methyl or hydrogen, and at least two of $R^{11}$ to $R^{15}$ may be hydrogen. More specifically, the siloxane-based polymer may be a compound in which $R^{11}$ and $R^{12}$ of Chemical Formula 2 are each independently methyl and hydrogen, and $R^{13}$ to $R^{15}$ of Chemical Formula 3 are each independently

methyl or hydrogen (e.g., polymethylhydrosiloxane whose terminal end group is a trimethylsilyl group or a dimethylhydrosilyl group); a compound in which some $R^{11}$ and $R^{12}$ of Chemical Formula 2 are methyl and hydrogen, respectively, both the remaining $R^{11}$ and $R^{12}$ are methyl, and $R^{13}$ to $R^{15}$ of Chemical Formula 3 are each independently methyl or hydrogen (e.g., poly(dimethylsiloxane-co-methylhydrosiloxane) whose terminal end group is a trimethylsilyl group or a dimethylhydrosilyl group); or a compound in which both $R^{11}$ and $R^{12}$ of Chemical Formula 2 are methyl, at least one of $R^{13}$ to $R^{15}$ of Chemical Formula 3 is hydrogen, and the remainder are each independently methyl or hydrogen (e.g., polydimethylsiloxane in which either or both of the terminal end groups are dimethylhydrosilyl groups).

The siloxane-based polymer may have a number average molecular weight (Mn) in the range of 200 to 4,000 as an example. Specifically, the lower limit of the number average molecular weight of the siloxane-based polymer may be, for example, 200 or more, 250 or more, 300 or more, or 350 or more, and the upper limit thereof may be, for example, 3,500 or less, 3,000 or less, 2,500 or less, 2,000 or less, 1,500 or less, or 1,000 or less. When the number average molecular weight of the siloxane-based polymer satisfies the above range, it is possible to prevent the problems that during the crosslinking process with an acrylic-based polyol which is performed at room temperature or higher, the siloxane-based polymer volatilizes and the degree of matrix crosslinking decreases, or the siloxane-based polymer has poor compatibility with other components of the photopolymer composition and thus, phase separation occurs between the components, thereby allowing the hologram recording medium formed from the photopolymer composition to exhibit excellent optical recording characteristics and durability under high temperature conditions.

The number average molecular weight means a number average molecular weight (unit: g/mol) in terms of polystyrene determined by GPC method. In the process of determining the number average molecular weight in terms of polystyrene measured by the GPC method, a commonly known analyzing device, a detector such as a refractive index detector, and an analytical column may be used, and commonly applied conditions for temperature, solvent, and flow rate may be used. Specific examples of the measurement conditions may include a temperature of 25°C, tetrahydrofuran solvent and a flow rate of 1 mL/min.

The acrylic-based polyol may mean a polymer in which one or more, specifically two or more, hydroxy groups are bonded to the main chain or side chain of an acrylate-based polymer. Unless specifically stated otherwise, "acrylic-based" as used herein refers to one or more selected from the group consisting of acryloyl group, methacryloyl group and derivatives thereof, or a repeating unit formed by polymerization thereof. Unless specifically stated otherwise, "acrylate-based" as used herein refers to one or more selected from the group consisting of acrylate and methacrylate, or a repeating unit formed by polymerization thereof.

The acrylic-based polyol is a homopolymer of an acrylate-based monomer having a hydroxy group, a copolymer of two or more types of acrylate-based monomers having a hydroxy group, or a copolymer of an acrylate-based monomer having a hydroxy group and an acrylate-based monomer having no hydroxy group. As used herein, "copolymer" is a term that encompasses all of a random copolymer, a block copolymer and a graft copolymer, unless otherwise specified.

The acrylate-based monomer having a hydroxy group may include, for example, hydroxyalkyl (meth)acrylate, hydroxyaryl (meth)acrylate, or the like, the alkyl is an alkyl having 1 to 30 carbon atoms, and the aryl may be an aryl having 6 to 30 carbon atoms. Further, the acrylate-based monomer having no hydroxy group may include, for example, an alkyl (meth)acrylate, an aryl (meth)acrylate, or the like, the alkyl may be an alkyl having 1 to 30 carbon atoms, and the aryl may be an aryl having 6 to 30 carbon atoms. Unless specifically stated otherwise, "(meth)acrylate" as used herein refers to acrylate and/or methacrylate.

The acrylic-based polyol may have a weight average molecular weight (Mw) in the range of 150,000 to 1,000,000 as an example. The weight average molecular weight means a weight average molecular weight in terms of polystyrene measured by the GPC method as described above. For example, the lower limit of the weight average molecular weight may be 150,000 or more, 200,000 or more, or 250,000 or more, and the upper limit thereof may be, for example, 900,000 or less, 850,000 or less, 800,000 or less, 750,000 or less, 700,000 or less, 650,000 or less, 600,000 or less, 550,000 or less, 500,000 or less, or 450,000 or less. When the weight average molecular weight of the acrylic-based polyol satisfies the above range, the polymer matrix sufficiently exerts the function as a support and thus, the recording properties for optical information less decrease even after the usage time has passed, and sufficient flexibility is imparted to the polymer matrix, thereby being able to improve the mobility of components (e.g., photoreactive monomer or plasticizer, etc.) contained in the photopolymer composition, and minimize the decrease in recording properties for optical information.

In order to adjust the crosslinking density of the acrylic-based polyol by the siloxane-based polymer at a level that is advantageous for ensuring the function of the hologram recording medium, the hydroxyl group equivalent of the acrylic-based polyol may be adjusted to an appropriate level.

Specifically, the hydroxyl group (-OH) equivalent of the acrylic-based polyol may be, for example, in the range of 500 to 3,000 g/equivalent. More specifically, the lower limit of the hydroxyl group (-OH) equivalent of the acrylic-based polyol may be 600 g/equivalent or more, 700 g/equivalent or more, 800 g/equivalent or more, 900 g/equivalent or more, 1000 g/equivalent or more, 1100 g/equivalent or more, 1200 g/equivalent or more, 1300 g/equivalent or more, 1400 g/equivalent or more, 1500 g/equivalent or more, 1600 g/equivalent or more, 1700 g/equivalent or more, or 1750 g/equivalent or more. And, the upper limit of the hydroxyl group (-OH) equivalent of the acrylic-based polyol may be

2900 g/equivalent or less, 2800 g/equivalent or less, 2700 g/equivalent or less, 2600 g/equivalent or less, 2500 g/equivalent or less, 2400 g/equivalent or less, 2300 g/equivalent or less, 2200 g/equivalent or less, 2100 g/equivalent or less, 2000 g/equivalent or less, or 1900 g/equivalent or less. The hydroxyl group (-OH) equivalent of the acrylic-based polyol means the equivalent weight (g/equivalent) for each single hydroxyl group, and is the value obtained by dividing the weight average molecular weight of the acrylic-based polyol by the number of hydroxyl groups per molecule. Therefore, as the equivalent value is smaller, the density of the functional group is higher, and as the equivalent value is larger, the density of the functional group is smaller. When the hydroxyl (-OH) equivalent of the acrylic-based polyol satisfies the above range, the polymer matrix has an appropriate crosslinking density and thus, sufficiently performs the role of a support, and the mobility of the components included in the layer formed from the photopolymer composition is improved, which allows the initial refractive index modulation value to be maintained at an excellent level even as time passes without the problem of collapsing the boundary surfaces of the diffraction gratings generated after recording, thereby minimizing the decrease in recording properties for optical information.

For example, the acrylic-based polyol may have a glass transition temperature (Tg) in the range of -60 to -10°C. Specifically, the lower limit of the glass transition temperature may be, for example, -55°C or more, -50°C or more, -45°C or more, -40°C or more, -35°C or more, -30°C or more, or -25°C or more, and the upper limit thereof may be, for example, -15°C or less, -20°C or less, -25°C or less, -30°C or less, or -35°C or less. If the above glass transition temperature range is satisfied, it is possible to lower the glass transition temperature without significantly reducing the modulus of the polymer matrix, thereby increasing the mobility (fluidity) of other components in the photopolymer composition, and also improving the moldability of the photopolymer composition. The glass transition temperature may be measured using a known method, for example, DSC (Differential Scanning Calorimetry) or DMA (dynamic mechanical analysis).

The refractive index of the acrylic-based polyol may be, for example, 1.40 or more and less than 1.50. Specifically, the lower limit of the refractive index of the acrylic-based polyol may be, for example, 1.41 or more, 1.42 or more, 1.43 or more, 1.44 or more, 1.45 or more, or 1.46 or more, and the upper limit thereof may be, for example, 1.49 or less, 1.48 or less, 1.47 or less, 1.46 or less, or 1.45 or less. When the acrylic-based polyol has a refractive index within the above-mentioned range, it can contribute to increasing the refractive index modulation. The refractive index of the acrylic-based polyol is a theoretical refractive index, and may be calculated using the refractive index (value measured using an Abbe refractometer at 25°C) of the monomer used for preparing the acrylic-based polyol and the fraction (molar ratio) of each monomer.

The acrylic-based polyol and the siloxane-based polymer may be included so that the molar ratio (SiH/OH) of the silane functional group (Si-H) of the siloxane-based polymer to the hydroxyl group (-OH) of the (meth)acrylic-based polyol is 0.80 to 3.5. That is, the type and content of the siloxane-based polymer and the acrylic-based polyol may be selected so as to satisfy the molar ratio when forming the polymer matrix. The lower limit of the molar ratio (SiH/OH) may be, for example, 0.81 or more, 0.85 or more, 0.90 or more, or 0.95 or more, and the upper limit thereof may be, for example, 3.4 or less, 3.3 or less, 3.2 or less, 3.1 or less, 3.05 or less, or 3.0 or less. When satisfying the above molar ratio (SiH/OH) range, the polymer matrix is crosslinked at an appropriate crosslinking density, so that reliability under high temperature conditions is improved, and a sufficient refractive index modulation value can be realized.

The Pt-based catalyst may be, for example, Karstedt's catalyst, and the like. The precursor of the polymer matrix may optionally further include rhodium-based catalysts, iridium-based catalysts, rhenium-based catalysts, molybdenum-based catalysts, iron-based catalysts, nickel-based catalysts, alkali metal or alkaline earth metal-based catalysts, Lewis acids-based or carbene-based non-metallic catalysts, in addition to the Pt-based catalyst.

On the other hand, a hologram recording medium may be prepared by irradiating an object light and a reference light onto a photopolymer layer formed from the photopolymer composition according to one embodiment of the disclosure. Due to the interference field between the object light and the reference light, photopolymerization of the photoreactive monomer does not occur in the destructive interference region, but photopolymerization of the photoreactive monomer occurs in the constructive interference region. As the photoreactive monomer is continuously consumed in the constructive interference region, a concentration difference occurs between the photoreactive monomer in the destructive interference region and the constructive interference region, and as a result, the photoreactive monomer in the destructive interference region diffuses into the constructive interference region. A diffraction grating is generated by the refractive index modulation thus generated.

Therefore, the photoreactive monomer may include a compound having a higher refractive index than the polymer matrix in order to realize the above-described refractive index modulation. However, all photoreactive monomers contained in the photopolymer composition according to one embodiment of the disclosure are not limited to those having a higher refractive index than the polymer matrix, and at least a part of the photoreactive monomers may have a higher refractive index than the polymer matrix, so as to realize a high refractive index modulation value. In one example, the photoreactive monomer may include a monomer having a refractive index of 1.50 or more, 1.51 or more, 1.52 or more, 1.53 or more, 1.54 or more, 1.55 or more, 1.56 or more, 1.57 or more, 1.58 or more, 1.59 or more, or 1.60 or more, and 1.70 or less.

The photoreactive monomer may include at least one monomer selected from the group consisting of a

monofunctional monomer having one photoreactive functional group and a polyfunctional monomer having two or more photoreactive functional groups. Wherein, the photoreactive functional group may be, for example, a (meth)acryloyl group, a vinyl group, a thiol group, or the like. More specifically, the photoreactive functional group may be a (meth)acryloyl group.

The monofunctional monomer may include, for example, at least one selected from the group consisting of benzyl (meth)acrylate (M1182 having a refractive index of 1.5140, Miwon Specialty Chemical), benzyl 2-phenylacrylate, phenoxybenzyl (meth)acrylate (M1122 having a refractive index of 1.565, Miwon Specialty Chemical), phenol (ethylene oxide) (meth)acrylate (phenol (EO) (meth)acrylate, M140 having a refractive index of 1.516, Miwon Specialty Chemical), phenol (ethylene oxide)$_2$ (meth)acrylate (phenol (EO)$_2$ (meth)acrylate; M142 having a refractive index of 1.510, Miwon Specialty Chemical), O-phenylphenol (ethylene oxide) (meth)acrylate (O-phenylphenol (EO) (meth)acrylate; M1142 having a refractive index of 1.577, Miwon Specialty Chemical), phenylthioethyl (meth)acrylate (M1162 having a refractive index of 1.560, Miwon Specialty Chemical) and biphenylmethyl (meth)acrylate.

The polyfunctional monomer may include, for example, at least one selected from the group consisting of bisphenol A (ethylene oxide)$_{2\sim10}$ di(meth)acrylate (bisphenol A (EO)$_{2\sim10}$ (meth)acrylate; M240 having a refractive index of 1.537, M241 having a refractive index of 1.529, M244 having a refractive index of 1.545, M245 having a refractive index of 1.537, M249 having a refractive index of 1.542, M2100 having a refractive index of 1.516, M2101 having a refractive index of 1.512, Miwon Specialty Chemical), bisphenol A epoxy di(meth)acrylate (PE210 having a refractive index of 1.557, PE2120A having a refractive index of 1.533, PE2120B having a refractive index of 1.534, PE2020C having a refractive index of 1.539, PE2120S having a refractive index of 1.556, Miwon Specialty Chemical), bisfluorene di(meth)acrylate (HR6022 having a refractive index of 1.600, HR6040 having a refractive index of 1.600, HR6042 having a refractive index of 1.600, Miwon Specialty Chemical), modified bisphenol fluorene di(meth)acrylate (HR6060 having a refractive index of 1.584, HR6100 having a refractive index of 1.562, HR6200 having a refractive index of 1.530, Miwon Specialty Chemical), tris(2-hydroxyethyl)isocyanurate tri(meth)acrylate (M370 having a refractive index of 1.508, Miwon Specialty Chemical), phenol novolac epoxy (meth)acrylate (SC6300 having a refractive index of 1.525, Miwon Specialty Chemical) and cresol novolac epoxy (meth)acrylate (SC6400 having a refractive index of 1.522, SC6400C having a refractive index of 1.522, Miwon Specialty Chemical).

The photopolymer composition according to one embodiment of the disclosure may contain a photoreactive monomer in an amount of 50 to 300 parts by weight based on 100 parts by weight of the polymer matrix. For example, the lower limit of the content of the photoreactive monomer may be 50 parts by weight or more, 60 parts by weight or more, 70 parts by weight or more, 80 parts by weight or more, or 90 parts by weight or more, and the upper limit thereof may be 300 parts by weight or less, 280 parts by weight or less, 250 parts by weight or less, 220 parts by weight or less, 200 parts by weight or less, 190 parts by weight or less, or 180 parts by weight or less. When the above range is satisfied, it is advantageous for ensuring excellent optical recording characteristics and durability under high temperature conditions.

In this specification, the content of the polymer matrix means the total content (weight) of the acrylic-based polyol and siloxane-based polymer forming the matrix. In other words, the content of the polymer matrix means including both the content of the polymer matrix formed by crosslinking acrylic-based polyol and siloxane-based polymer and the content of the polymer matrix precursor that is not partially crosslinked.

The photopolymer composition according to one embodiment of the disclosure comprises a photosensitizing dye and a co-initiator in order to initiate polymerization by light.

The photosensitizing dye may comprise a compound that includes a core represented by the following Chemical Formula 1, and has an openness of 7.0 to 8.5 Å$^2$ for the double bond connecting two hetero rings.

[Chemical Formula 1]

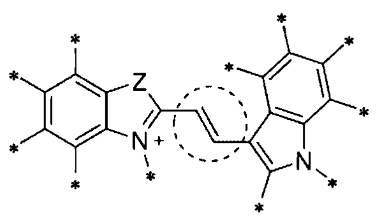

in Chemical Formula 1,

Z is oxygen, sulfur, or $CR^7R^8$,
$R^7$ and $R^8$ are each independently an alkyl group having 1 to 6 carbon atoms.

The core of Chemical Formula 1 has a structure in which two hetero rings

( 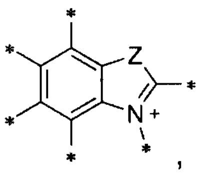 , 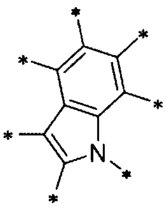 )

are connected via a double bond shown by a dotted line.

The core represented by Chemical Formula 1 is the parent structure of the compound comprising it and -* denotes a bond linking to hydrogen or a substituent in Chemical Formula 1.

When a compound including the core represented by Chemical Formula 1 and having an openness of 7.0 to 8.5 $Å^2$ for double bond (indicated by the dotted line) connecting two hetero rings is used, the thermal stability of the hologram recording medium before recording can be significantly improved.

The openness of the double bond may be defined as the sum of the openness values calculated separately for each of the two carbon atoms forming the double bond.

The openness of each carbon atom is defined as the unshielded surface area at a certain distance from the carbon atom. Specifically, the openness is defined as the open surface area not blocked by substituents with respect to the surface area of a sphere with a radius r of a certain distance from the carbon atom. Wherein the certain distance means a distance of about 1.0 to 1.4 Å or about 1.2 Å from the center of the carbon atom. Thus, the openness of each carbon atom is the open surface area not blocked by substituents with respect to the surface area of a sphere with a radius of about 1.0 to 1.4 Å or about 1.2 Å from the center of the carbon atom.

The openness may be determined using Jmol software on the optimized structure obtained from a quantum chemical calculation program. Specifically, the openness may be determined using Jmol software with a density functional theory (DFT) method using a quantum chemical calculation program, by applying the functional B3LYP with a 6-31G* basis set according to the method described in the Examples hereinafter.

An openness of 7.0 to 8.5 $Å^2$ for the double bond means that the double bond is shielded by substituents, so it is difficult for other components of the hologram recording medium to access the double bond, thus making it less likely to cause side reactions.

However, contrary to an initial expectation that the smaller the openness, the better the thermal stability, the present inventors found that if the openness value becomes smaller than a certain level, the thermal stability actually deteriorates, and optical recording characteristics or transparency also decline. In other words, only when the openness of the double bond is within a certain range can it provide a hologram recording medium with excellent thermal stability before recording.

The upper limit of the openness of the double bond may be, for example, 8.50 $Å^2$ or less, 8.45 $Å^2$ or less, 8.43 $Å^2$ or less, or 8.41 $Å^2$ or less and the lower limit may be, for example, 7.0 $Å^2$ or more, 7.5 $Å^2$ or more, 8.0 $Å^2$ or more, or 8.1 $Å^2$ or more.

In one example, the compound including the core of Chemical Formula 1 and having an openness of 7.0 to 8.5 $Å^2$ for the double bond connecting two hetero rings may be a compound represented by the following Chemical Formula 1-1.

[Chemical Formula 1-1]

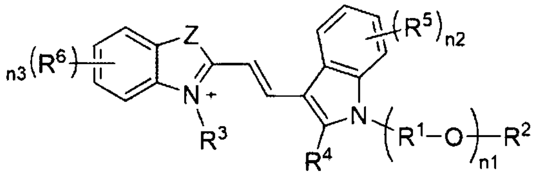

in Chemical Formula 1-1,

$R^1$ is an alkylene group having 1 to 6 carbon atoms, $R^2$ is an alkyl group having 1 to 6 carbon atoms,
n1 is an integer of 1 to 6,
$R^3$ is an alkyl group having 3 to 12 carbon atoms,
$R^4$ is hydrogen or an alkyl group having 1 to 6 carbon atoms,
$R^5$ and $R^6$ are each independently a halogen, a hydroxyl group, an alkyl group having 1 to 6 carbon atoms, or an alkoxy group having 1 to 6 carbon atoms,
n2 and n3 are each independently an integer of 0 to 4,

Z is oxygen, sulfur, or $CR^7R^8$,
$R^7$ and $R^8$ are each independently an alkyl group having 1 to 6 carbon atoms.

In Chemical Formula 1-1, $R^1$ may be, for example, methylene group, 1,2-ethylene group, 1,3-propylene group, 1,2-propylene group, 1,4-butylene group, 1,3-butylene group, 1,2-butylene group, or isobutylene group. Specifically, $R^1$ may be, for example, 1,2-ethylene group, 1,2-propylene group, or isobutylene group. More specifically, $R^1$ may be, for example, 1,2-ethylene group.

In Chemical Formula 1-1, $R^2$ may be, for example, methyl, ethyl, n-propyl, isopropyl, 1-butyl, 2-butyl, isobutyl, or t-butyl. Specifically, $R^2$ may be, for example, methyl, ethyl, or n-propyl. More specifically, $R^2$ may be, for example, methyl.

In Chemical Formula 1-1, n1 may be, for example, an integer of 1 to 4, an integer of 1 to 3, or an integer of 1 to 2.

In Chemical Formula 1-1, $R^3$ may be, for example, a branched chain or cyclic alkyl group having 3 to 12 carbon atoms. Specifically, $R^3$ may be, for example, isopropyl, isobutyl, t-butyl, isopentyl, 1-methyl-1-butyl, 2-methyl-2-butyl, t-pentyl, isohexyl, 1-methyl-1-pentyl, 2-methyl-1-pentyl, 3-methyl-1-pentyl, t-hexyl, 2,2-dimethyl-1-butyl, 3,3-dimethyl-1-butyl, cyclopropyl, cyclobutyl, cyclopentyl, cyclohexyl, cyclopropylmethyl, cyclobutylmethyl, cyclopentylmethyl, cyclohexylmethyl, cyclopropylethyl, cyclobutylethyl, cyclopentylethyl, or cyclohexylethyl. More specifically, $R^3$ may be, for example, isopropyl, isobutyl, t-butyl, isopentyl, isohexyl, 2,2-dimethyl-1-butyl, or 3,3-dimethyl-1-butyl.

In Chemical Formula 1-1, $R^4$ may be, for example, hydrogen, methyl group, or ethyl group. More specifically, $R^4$ may be, for example, hydrogen.

In Chemical Formula 1-1, $R^5$and $R^6$ may be, for example, each independently halogen, hydroxyl group, an alkyl group having 1 to 6 carbon atoms, or an alkoxy group having 1 to 6 carbon atoms. More specifically, $R^5$ and $R^6$ may be, for example, each independently fluorine, chlorine, methyl, ethyl, methoxy, or ethoxy.

In Chemical Formula 1-1, n2 and n3 may be, for example, each independently an integer of 0 to 4, an integer of 0 to 3, an integer of 0 to 2, an integer of 0 to 1, or 0.

In Chemical Formulas 1 and 1-1, Z may be, for example, oxygen, sulfur, or $CR^7R^8$, wherein $R^7$ and $R^8$ may be, for example, each independently an alkyl group having 1 to 3 carbon atoms. Specifically, Z may be, for example, oxygen, sulfur, or 2,2-propylene group. More specifically, Z may be, for example, 2,2-propylene group.

The photosensitizing dye may further comprise an anion as a counter ion to the cationic compound including the core represented by Chemical Formula 1. The type of anion is not particularly limited, and may be, for example, a tetraaryl borate. The four aryl groups of the tetraaryl borate may be the same or different from each other, and may be, for example, a substituted or unsubstituted aryl group having 6 to 30 carbon atoms, a substituted or unsubstituted arylalkyl group having 7 to 30 carbon atoms, or a substituted or unsubstituted alkylaryl group having 7 to 30 carbon atoms.

In this specification, "substituted or unsubstituted" means that hydrogen or carbon is substituted by another atom unless otherwise defined. In one example, hydrogen may be substituted by a halogen, a vinyl group, a hydroxy group, an alkyl group having 1 to 10 carbon atoms, a haloalkyl group having 1 to 10 carbon atoms, or an alkoxy group having 1 to 10 carbon atoms, and carbon ($-CH_2-$) may be substituted by -O- or -CO-.

In one example, the tetraaryl borate may be at least one anion selected from the group consisting of tetra(phenyl) borate, tetrakis(fluorophenyl) borate, tetrakis(chlorophenyl) borate, tetrakis(methylphenyl) borate, tetrakis(methoxyphenyl) borate, tetrakis(fluoromethylphenyl) borate, tetrakis(fluoromethoxyphenyl) borate, tetrakis(chloromethylphenyl) borate, and tetrakis(chloromethoxyphenyl) borate.

When a compound including the core represented by Chemical Formula 1 and having an openness of 7.0 to 8.5 $Å^2$ for the double bond connecting two hetero rings is used as a photosensitizing dye, it is possible to enable optical recording in the blue region and to provide a hologram recording medium with excellent optical recording characteristics and thermal stability.

The photopolymer composition according to one embodiment of the disclosure may further comprise other photosensitizing dye enabling optical recording in the blue, red, or green regions, in addition to the compound including the core represented by Chemical Formula 1 and having an openness of 7.0 to 8.5 $Å^2$ for the double bond connecting two hetero rings.

The photosensitizing dye may include, for example, at least one selected from the group consisting of a silicon rhodamine compound, a sulfonium derivative of ceramidonine, new methylene blue, thioerythrosine triethylammonium, 6-acetylamino-2-methylceramidonin, eosin, erythrosine, rose bengal, thionine, basic yellow, Pinacyanol chloride, rhodamine 6G, gallocyanine, ethyl violet, Victoria blue R, Celestine blue, Quinaldine Red, Crystal violet, Brilliant Green, Astrazon orange G, darrow red, pyronin Y, basic red 29, pyrylium I (pyrylium iodide), Safranin O, cyanine, methylene blue, Azure A, and BODIPY. Note that Astrazon Orange G is also a compound including the core represented by Chemical Formula 1, but since it has an openness of 9.99 $Å^2$ for the double bond connecting hetero rings, it does not exhibit the optical recording characteristics and thermal stability intended in the present disclosure.

The photopolymer composition of one embodiment may include the photosensitizing dye in an amount of 0.01 to 10 parts by weight based on 100 parts by weight of the polymer matrix. Specifically, the lower limit of the content of the photosensitizing dye may be, for example, 0.05 parts by weight or more, 0.07 parts by weight or more, or 0.10 parts by

weight or more, and the upper limit may be, for example, 5 parts by weight or less. When the above range is satisfied, it is advantageous for exhibiting an appropriate polymerization reaction rate and ensuring desired optical recording characteristics.

The co-initiator may include an electron donor, an electron acceptor, or a mixture thereof.

In one example, the photopolymer composition of one embodiment may include an electron donor as a co-initiator. The electron donor may include, for example, a borate anion represented by the following Chemical Formula 4.

[Chemical Formula 4] $BX^1X^2X^3X^4$

in Chemical Formula 4, $X^1$ to $X^4$ are each independently an alkyl group having 1 to 20 carbon atoms, an alkenyl group having 2 to 20 carbon atoms, an aryl group having 6 to 30 carbon atoms, an arylalkyl group having 7 to 30 carbon atoms, an alkylaryl group having 7 to 30 carbon atoms, or an allyl group, each of which is substituted or unsubstituted, with the proviso that at least one of $X^1$ to $X^4$ is not an aryl group.

When the alkyl group having 1 to 20 carbon atoms, the alkenyl group having 2 to 20 carbon atoms, the aryl group having 6 to 30 carbon atoms, the arylalkyl group having 7 to 30 carbon atoms, the alkylaryl group having 7 to 30 carbon atoms, or the allyl group is substituted, it may be substituted with at least one selected from the group consisting of a halogen, a vinyl group, a haloalkyl group having 1 to 5 carbon atoms, and an alkoxy group having 1 to 5 carbon atoms.

Specifically, $X^1$ to $X^3$ may be each independently phenyl, methylphenyl, naphthyl or methylnaphthyl which is substituted or unsubstituted with at least one substituent selected from the group consisting of halogen, vinyl, and methoxy groups, and $X^4$ may be a straight chain alkyl group having 1 to 12 carbon atoms.

In one example, the co-initiator may include at least one borate anion selected from the group consisting of borate anions represented by the following Chemical Formulas 4-1 and 4-2.

[Chemical Formula 4-1]

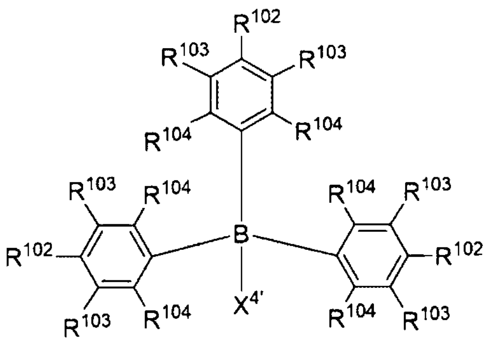

in Chemical Formula 4-1,

$R^{102}$, $R^{103}$, and $R^{104}$ are each independently hydrogen, methyl, methoxy, halogen, phenyl, or vinyl, and
$X^{4'}$ is a straight chain alkyl group having 1 to 12 carbon atoms.

[Chemical Formula 4-2]

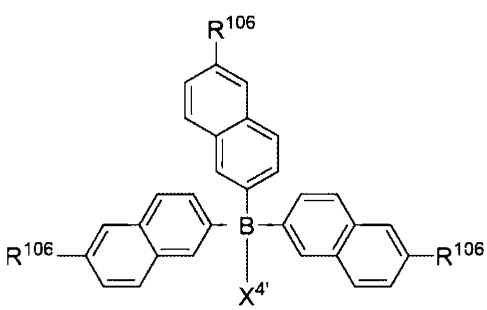

in Chemical Formula 4-2,

each $R^{106}$ is independently hydrogen, methyl, methoxy, halogen, or vinyl, and

$X^{4''}$ is a straight chain alkyl group having 1 to 12 carbon atoms.

In Chemical Formulas 4-1 and 4-2, a plurality of $R^{102}$, $R^{103}$, $R^{104}$ and $R^{106}$ may be the same or different from each other. For example, in Chemical Formula 4-1, two $R^{103}$ substituents on one phenyl ring may be the same or different from each other, and two $R^{104}$ substituents may also be the same or different from each other.

In Chemical Formula 4-1, $R^{102}$, $R^{103}$, and $R^{104}$ may be, for example, each independently hydrogen, F, Cl, or methyl. Specifically, $R^{102}$ may be, for example, each independently hydrogen, or Cl. $R^{103}$ may be, for example, hydrogen. $R^{104}$ may be, for example, hydrogen, Cl, or methyl. More specifically, $R^{102}$ may be, for example, Cl. $R^{103}$ may be, for example, hydrogen. $R^{104}$ may be, for example, hydrogen, or methyl.

In Chemical Formula 4-1, $X^{4'}$ may be, for example, butyl group, pentyl group, hexyl group, heptyl group, or octyl group.

In Chemical Formula 4-2, $R^{106}$ may be, for example, each independently hydrogen, halogen, or methyl. Specifically, $R^{106}$ may be, for example, hydrogen, F, Cl, or methyl.

The cation bonded to the borate anion does not absorb light, and may be at least one cation selected from the group consisting of an alkali metal cation, a quaternary ammonium cation, and a nitrogen-containing heterocyclic cation.

The alkali metal cation may be, for example, at least one selected from the group consisting of lithium, sodium, potassium, rubidium, and cesium.

The quaternary ammonium cation may be an ammonium cation in which nitrogen (N) is substituted with four substituents, or a cyclic ammonium cation in which two substituents substituted on nitrogen are connected with each other, or a mixture thereof.

The nitrogen-containing heterocyclic cation may be a heteroaromatic ring cation containing one or more nitrogen. Examples of such heteroaromatic ring cations include cations of pyrrole, pyrazole, imidazole, or pyridine, and the hydrogen thereof may be substituted or unsubstituted.

Specifically, the quaternary ammonium cation may include a cation represented by the following Chemical Formula 4-3.

[Chemical Formula 4-3] $NY^1Y^2Y^3Y^4$

in Chemical Formula 4-3, two substituents of $Y^1$ to $Y^4$ may or may not be connected with each other to form an aliphatic ring having 4 to 10 carbon atoms, and

$Y^1$ to $Y^4$, which do not form an aliphatic ring, are each independently an alkyl group having 1 to 40 carbon atoms, an aryl group having 6 to 30 carbon atoms, an arylalkyl group having 6 to 40 carbon atoms, or an alkyl group having 2 to 40 carbon atoms connected through an ester bond (e.g.,$-CH_2CH_2-O-CO-CH_2CH_2CH_3$,etc.),

with the proviso that a case where $Y^1$ to $Y^4$ are all methyl groups, or two or more substituents are alkyl groups having 16 or more carbon atoms is excluded.

In Chemical Formula 4-3, if $Y^1$ to $Y^4$ are all methyl groups, or two or more substituents are alkyl groups having 16 or more carbon atoms, the electron donor may not dissolve well in the photopolymer composition, and thus may not exhibit desired optical recording characteristics.

Specifically, among $Y^1$ to $Y^4$, two substituents may be connected with each other to form piperidine or pyrrolidine.

Among the $Y^1$ to $Y^4$, the substituents that do not form an aliphatic ring may each independently be a straight chain alkyl group having 1 to 32 carbon atoms, a phenyl group, a benzyl group, or $-CH_2CH_2-O-CO-CH_2CH_2CH_3$. More specifically, among the $Y^1$ to $Y^4$, the substituents that do not form an aliphatic ring may be each independently a methyl group, a butyl group, a hexadecyl group, a hentriacontyl group, a phenyl group, or a benzyl group.

Meanwhile, the nitrogen-containing heterocyclic cation may include a cation represented by the following Chemical Formula 4-4.

[Chemical Formula 4-4]

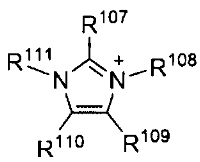

in Chemical Formula 4-4, $R^{107}$, $R^{109}$ and $R^{110}$ are each independently hydrogen, an alkyl group having 1 to 40 carbon atoms, an aryl group having 6 to 30 carbon atoms, an arylalkyl group having 6 to 40 carbon atoms, or an alkyl group

having 2 to 40 carbon atoms connected through an ester bond (e.g., $-CH_2CH_2-O-CO-CH_2CH_2CH_3$, etc.), and $R^{108}$ and $R^{111}$ are each independently an alkyl group having 1 to 40 carbon atoms, an aryl group having 6 to 30 carbon atoms, an arylalkyl group having 6 to 40 carbon atoms, or an alkyl group having 2 to 40 carbon atoms connected through an ester bond (e.g., $-CH_2CH_2-O-CO-CH_2CH_2CH_3$, etc.).

Specifically, $R^{107}$, $R^{109}$, and $R^{110}$ may be, for example, each independently hydrogen or an aryl group having 6 to 30 carbon atoms. More specifically, $R^{107}$, $R^{109}$, and $R^{110}$ may be, for example, each independently hydrogen or a phenyl group.

Specifically, the $R^{108}$ and $R^{111}$ may be, for example, a straight chain alkyl group having 1 to 40 carbon atoms or an arylalkyl group having 6 to 40 carbon atoms. More specifically, the $R^{108}$ and $R^{111}$ may be, for example, a hexadecyl group or a benzyl group.

The cation bonded to the borate anion may include, for example, at least one selected from the group consisting of tetrabutyl ammonium cation, hexadecyl dimethyl benzyl ammonium cation, hentriacontyl dimethyl benzyl ammonium cation, hexadecyl benzyl piperidinium cation, hexadecyl benzyl pyrrolidinium cation, 1-hexadecyl-3-benzylimidazolium cation and 1,3-dihexadecyl-2-phenylimidazolium cation as a cation represented by the Chemical Formulas 4-3 and 4-4.

However, the cation bonded to the borate anion is not limited to the above-mentioned cations, and even if it shows poor solubility when contained alone, some of the above-mentioned cations may be substituted with other cations known in the related art, as long as it can show adequate solubility when mixed with the above-mentioned cations. By way of non-limiting example, some of the above-mentioned cations may be substituted with 1,2-dicyclohexyl-4,4,5,5-tetramethylbiguanidium, etc.

In one example, the photopolymer composition may include an electron acceptor as a co-initiator. The electron acceptor may include, for example, onium salts such as sulfonium salts and iodonium salts; triazine compounds such as tris(trihalomethyl)triazine, substituted bis(trihalomethyl)triazine, etc.; or a mixture thereof.

Specifically, the electron acceptor may include (4-(octyloxy)phenyl)(phenyl)iodonium salt as an iodonium salt, or 2-(4-methoxyphenyl)-4,6-bis(trichloromethyl)-1,3,5-triazine as the triazine compound. Examples of the electron acceptor include commercially available H-Nu 254 (Spectra Group) or 2-(4-methoxyphenyl)-4,6-bis(trichloromethyl)-1,3,5-triazine (TCI America).

The photopolymer composition may include the co-initiator in the range of 0.1 to 50 parts by weight based on 100 parts by weight of the polymer matrix. Specifically, the lower limit of the content of the co-initiator may be, for example, 1 parts by weight or more, 3 parts by weight or more, 5 parts by weight or more, 6 parts by weight or more, or 7 parts by weight or more, and the upper limit thereof may be, for example, 30 parts by weight or less. When the above range is satisfied, it is advantageous for exhibiting an appropriate polymerization reaction rate and ensuring desired optical recording characteristics.

In one example, the thermal stability of the hologram recording medium can be further enhanced by adjusting the mixing ratio of the photosensitizing dye, that is the compound including the core represented by Chemical Formula 1 and having an openness of 7.0 to 8.5 Å$^2$ for the double bond connecting two hetero rings, and the electron donor represented by Chemical Formulas 4-1 and 4-2. More specifically, the thermal stability of the hologram recording medium before recording can be greatly improved by adjusting the mixing ratio of the specific photosensitizing dye and the specific electron donor.

For example, the thermal stability of the hologram recording medium before recording can be significantly improved by mixing 0.1 to 10 moles of the borate anion represented by Chemical Formulas 4-1 and 4-2 with per 1 mole of the compound including the core represented by Chemical Formula 1 and having an openness of 7.0 to 8.5 Å$^2$ for the double bond connecting two hetero rings.

Specifically, the borate anion represented by Chemical Formulas 4-1 and 4-2 may be mixed in an amount of 0.1 mole or more, 0.5 mole or more, 1 mole or more, or 2 mole or more, and 10 mole or less, 8 mole or less, 7 mole or less, 6 mole or less, or 5 mole or less, based on 1 mole of the compound including the core represented by Chemical Formula 1 and having an openness of 7.0 to 8.5 Å$^2$ for the double bond connecting two hetero rings.

The photopolymer composition according to one embodiment of the disclosure may include an additional photoinitiator in order to remove the color of the photosensitizing dye and react all unreacted photoreactive monomers after light irradiation for recording. The photoinitiator may include, for example, acetophenone-based compounds, oxime-based compounds, phosphine oxide-based compounds, thioxanthone-based compounds, benzoate-based compounds, imidazole-based compounds, N-aryl glycine derivatives, organic azide compounds, titanocenes, aluminate complexes, organic peroxides, N-alkoxy pyridinium salts, amine derivatives, diazonium salts, sulfonium salts, iodonium salts, sulfonates, imide sulfonates, dialkyl-4-hydroxysulfonium salts, aryl sulfonic acid-p-nitrobenzyl esters, silanol-aluminum complexes, ($\eta$6-benzene) ($\eta$5-cyclopentadienyl)iron(II), benzoin tosylate, 2,5-dinitrobenzyl tosylate, N-tosylphthalimide, or mixtures thereof, etc.

More specifically, the photoinitiator may include 2-methyl-1-[4-(methylthio)phenyl]-2-morpholinopropan-1-one, 2-benzyl-2-dimethylamino-1-(4-morpholinophenyl)-butan-1-one (Irgacure 369), 1-[9-ethyl-6-(2-methylbenzoyl)-9H-carbazol-3-yl]ethanone-1-(O-acetyl oxime) (Irgacure OXE02, BASF), [(Z)-(1-oxo-1-phenylpropan-2-ylidene)amino] benzoate (e.g., TPI-057 or TPI-059, manufactured by TREEEL), diphenyl(2,4,6-trimethylbenzoyl)phosphine oxide (Irgacure TPO), bis(2,6-dimethoxybenzoyl)-2,4,4-trimethylpentyl phosphine oxide (Irgacure 1700), phenylbis(2,4,6-trimethylbenzoyl)phosphine oxide (BAPO), bis(2,4,6-trimethylbenzoyl)phenylphosphine oxide (Irgacure 819), 2,4-diethyl thioxanthone, 2-chloro thioxanthone, isopropyl thioxanthone, diisopropyl thioxanthone, ethyl 4-(dimethylamino)benzoate, 1,3-di(t-butyldioxycarbonyl)benzophenone, 3,3',4,4"-tetrakis(t-butyldioxycarbonyl)benzophenone, 3-phenyl-5-isoxazoline, 2-mercaptobenzimidazole, bis(2,4,5-triphenyl)imidazole, 2,2-dimethoxy-1,2-diphenylethan-1-one (Irgacure 651), 1-hydroxycyclohexyl phenyl ketone (Irgacure 184), bis(η5-2,4-cyclopentadien-1-yl)-bis(2,6-difluoro-3-(1H-pyrrol-1-yl)phenyl)titanium (Irgacure 784), Ebecryl P-115 (SK entis), Cyracure UVI-6970, Cyracure UVI-6974, Cyracure UVI-6990 (Dow Chemical Co. in the USA), Irgacure 264, Irgacure 250 (BASF), CIT-1682 (Nippon Soda), or mixtures thereof, but are not limited thereto.

In one example, the photoinitiator may include a phosphine oxide-based compound.

The compound including the core represented by Chemical Formula 1 and having an openness of 7.0 to 8.5 $Å^2$ for the double bond connecting two hetero rings may improve the thermal stability of the hologram recording medium as its content increases. However, as the content of the compound increases, there could be an issue with the color difference (△E) becoming larger, which may make it challenging to exhibit colorless and transparent optical properties.

The phosphine oxide-based compound can sufficiently lower the increased △E due to the compound and increase the amount of the compound to a level where it exhibits excellent thermal stability.

Examples of phosphine oxide-based compounds may be at least one selected from the group consisting of diphenyl(2,4,6-trimethylbenzoyl)phosphine oxide (Irgacure TPO), bis(2,6-dimethoxybenzoyl)-2,4,4-trimethylpentyl phosphine oxide (Irgacure 1700), phenylbis(2,4,6-trimethylbenzoyl)phosphine oxide (BAPO), and bis(2,4,6-trimethylbenzoyl)phenylphosphine oxide (Irgacure 819).

The photopolymer composition according to one embodiment of the disclosure may include the photoinitiator in the range of 0.1 to 10 parts by weight based on 100 parts by weight of the polymer matrix. Specifically, the lower limit of the content of the photoinitiator may be, for example, 0.1 parts by weight or more, 0.3 parts by weight or more, 0.5 part by weight or more, or 1.0 parts by weight or more, and the upper limit thereof may be, for example, 10 parts by weight or less, 8 parts by weight or less, or 5 parts by weight or less.

If the above range is satisfied, after optical information is recorded on the photopolymer layer, the reaction of the photoreactive monomer is effectively terminated, and the color of the photosensitizing dye is decolorized, thereby providing a transparent hologram recording medium.

The photopolymer composition according to one embodiment of the disclosure may further include a plasticizer. The plasticizer can more easily realize refractive index modulation upon recording a hologram recording medium. More specifically, the plasticizer lowers the glass transition temperature of the polymer matrix, improves the mobility of the photoreactive monomer, and has a low refractive index and non-reactive properties. Thus, when a photoreactive monomer that is uniformly distributed within the polymer matrix but is not photopolymerized moves, it can move in the direction opposite thereto and contribute to the refractive index modulation. Further, the plasticizer can also contribute to improving the moldability of photopolymer compositions.

The plasticizer may have a low refractive index of 1.45 or less in order to perform the above-mentioned plasticizer function. Specifically, the upper limit of the refractive index may be, for example, 1.44 or less, 1.43 or less, 1.42 or less, 1.41 or less, 1.40 or less, 1.39 or less, 1.38 or less, or 1.37 or less. The lower limit of the refractive index may be, for example, 1.30 or more, 1.31 or more, 1.32 or more, 1.33 or more, 1.34 or more, or 1.35 or more. Since a plasticizer having a lower refractive index than the above-mentioned photoreactive monomer is used, the refractive index of the polymer matrix can be further lowered, and the refractive index modulation with the photoreactive monomer can be made larger.

The photopolymer composition according to one embodiment of the disclosure may include, for example, a fluorinated compound as a plasticizer.

In one example, the plasticizer may include a fluorinated compound represented by the following Chemical Formula 5-1.

[Chemical Formula 5-1]

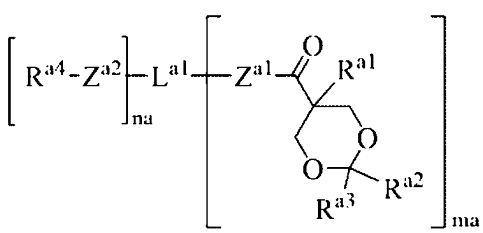

In Chemical Formula 5-1,

$Z^{a1}$ is -O- or -NH-,
$Z^{a2}$ is a single bond, -O-, or -NH-,
$L^{a1}$ is a single bond or a divalent to hexavalent organic group in which hydroxy groups have been removed from a polyol having 2 to 6 hydroxyl groups,
na and ma are each independently an integer of 1 to 5, wherein the sum of na and ma is 2 to 6,
$R^{a1}$, $R^{a2}$, and $R^{a3}$ are each independently methyl or ethyl,
$R^{a4}$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines.

In Chemical Formula 5-1, $L^{a1}$ connects the moiety containing a carbonyl group and the moiety containing $R^{a4}$. Therefore, the sum of na and ma is 2 to 6, which is equal to the number of bonds in $L^{a1}$.

In one example, in Chemical Formula 5-1, $L^{a1}$ may be a single bond. In Chemical Formula 5-1, when $L^{a1}$ is a single bond, na and ma are each 1, and $Z^{a2}$ may also be a single bond. In such a case, the fluorinated compound represented by Chemical Formula 5-1 may be represented by the following Chemical Formula 5-1-a.

[Chemical Formula 5-1-a]

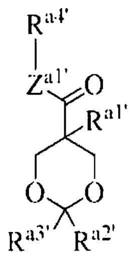

in Chemical Formula 5-1-a,
$Z^{a1'}$, $R^{a1'}$, $R^{a2'}$, $R^{a3'}$ and $R^{a4'}$ are the same as $Z^{a1}$, $R^{a1}$, $R^{a2}$, $R^{a3}$ and $R^{a4}$ in Chemical Formula 5-1, respectively. The $Z^{a1}$, $R^{a1'}$, $R^{a2'}$, $R^{a3'}$ and $R^{a4'}$ may be substituents described herein as specific examples of $Z^{a1}$, $R^{a1}$, $R^{a2}$, $R^{a3}$ and $R^{a4}$ of Chemical Formula 5-1.

In another example, in Chemical Formula 5-1, $L^{a1}$ may be a divalent to hexavalent organic group from which the hydroxyl groups have been removed from the polyol as the hydroxyl groups of the polyol having 2 to 6 hydroxyl groups are substituted with $Z^{a1}$ and $Z^{a2}$. In an example, the trivalent organic group from which the hydroxy groups have been removed from glycerol

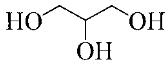

having three hydroxyl groups is represented as

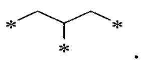

In Chemical Formula 5-1, the $L^{a1}$ may be, for example, a divalent organic group in which the hydroxy groups have been removed from a diol such as ethanediol, propanediol, or butanediol; a trivalent organic group in which the hydroxy groups have been removed from a triol such as glycerol or trimethylolpropane; a tetravalent organic group in which the hydroxy groups have been removed from tetraol such as pentaerythritol or ditrimethylolpropane; a pentavalent organic group in which the hydroxy groups have been removed from pentaol, such as 6-methylheptanepentaol; or a hexavalent organic group in which the hydroxy groups have been removed from hexaol such as dipentaerythritol.

In Chemical Formula 5-1, when $L^{a1}$ is a single bond or a divalent organic group, na and ma are each 1. If the $L^{a1}$ is a trivalent to hexavalent organic group, na may be larger than ma. In one example, the na may be an integer of 1 to 3, and ma may be an integer of 1.

In one example, the $L^{a1}$ may be a trivalent organic group in which the hydroxy groups have been removed from glycerol which is a triol. And, na may be 2, and ma may be 1. In such a case, the fluorinated compound represented by Chemical Formula 5-1 may be represented by the following Chemical Formula 5-1-b.

[Chemical Formula 5-1-b]

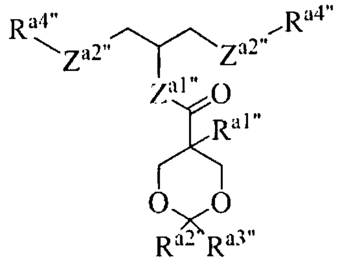

in Chemical Formula 5-1-b,
$Z^{a1"}$, $z^{a2"}$, $R^{a1"}$, $R^{a2"}$, $R^{a3"}$ and $R^{a4"}$ are the same as $Z^{a1}$, $Z^{a2}$, $R^{a1}$, $R^{a2}$, $R^{a3}$ and $R^{a4}$ of Chemical Formula 5-1, respectively. The $Z^{a1"}$, $Z^{a2"}$, $R^{a1"}$, $R^{a2"}$, $R^{a3"}$ and $R^{a4"}$ may be substituents described herein as specific examples of $Z^{a1}$, $Z^{a2}$, $R^{a1}$, $R^{a2}$, $R^{a3}$ and $R^{a4}$ of Chemical Formula 5-1.

In Chemical Formula 5-1, the fluorine-containing substituent may be an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines. Specifically, the fluorine-containing substituent may be a straight chain alkyl group having 1 to 20 carbon atoms substituted with 2 or more fluorines. More specifically, the fluorine-containing substituent may be $-(CH_2)_a(CF_2)_bCHF_2$ or $-(CH_2)_a(CF_2)_bCF_3$. Wherein a is an integer of 0 to 3, an integer of 0 to 2, or an integer of 1, and b may be an integer of 0 to 19, an integer of 0 to 15, an integer of 0 to 12, an integer of 0 to 11, an integer of 0 to 10, or an integer of 0 to 9.

Meanwhile, in another example, the plasticizer may include a fluorinated compound represented by the following Chemical Formula 5-2.

[Chemical Formula 5-2]

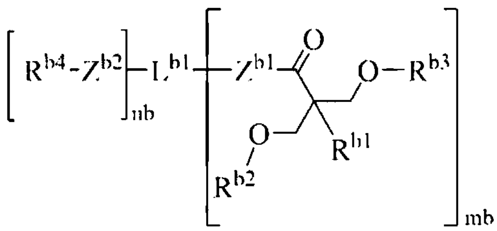

in Chemical Formula 5-2,

$Z^{b1}$ is -O- or -NH-,
$Z^{b2}$ is a single bond, -O- or -NH-,
$L^{b1}$ is a single bond or a divalent to hexavalent organic group in which hydroxy groups have been removed from a polyol having 2 to 6 hydroxyl groups,
nb and mb are each independently an integer of 1 to 5, wherein the sum of nb and mb is 2 to 6,
$R^{b1}$ is a methyl group or an ethyl group, and
at least one of $R^{b2}$ to $R^{b4}$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines,
when $R^{b2}$ and $R^{b3}$ are not fluorine-containing substituents, they are each independently hydrogen, an alkyl group having 1 to 20 carbon atoms, a cycloalkyl group having 3 to 30 carbon atoms, a heterocycloalkyl group having 4 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or are substituents in which at least one $-CH_2-$ of the above substituents is substituted with -O-, -S- or -NH-, and
when $R^{b4}$ is not a fluorine-containing substituent, it is an alkyl group having 2 to 20 carbon atoms, a cycloalkyl group having 3 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or is a substituent in which at least one $-CH_{2-}$ of the above substituents is substituted with -O-, -S-, or -NH-.

In Chemical Formula 5-2, $L^{b1}$ connects the moiety containing a carbonyl group and the moiety containing $R^{b4}$. Therefore, the sum of nb and mb is 2 to 6, which is equal to the number of bonds in $L^{b1}$.

In one example, in Chemical Formula 5-2, $L^{b1}$ may be a single bond. In Chemical Formula 5-2, when $L^{b1}$ is a single bond, nb and mb are each 1, and $Z^{b2}$ may also be a single bond. In such a case, the fluorinated compound represented by Chemical Formula 5-2 may be represented by the following Chemical Formula 5-2-a.

[Chemical Formula 5-2-a]

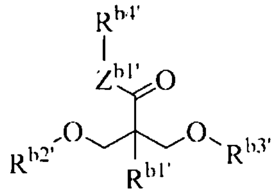

in Chemical Formula 5-2-a,

$Z^{b1'}$, $R^{b1'}$, $R^{b2'}$, $R^{b3'}$ and $R^{b4'}$ are the same as $Z^{b1}$, $R^{b1}$, $R^{b2}$, $R^{b3}$ and $R^{b4}$ in Chemical Formula 5-2, respectively. The $Z^{b1'}$, $R^{b1'}$, $R^{b2'}$, $R^{b3'}$ and $R^{b4'}$ may be substituents described herein as specific examples of $Z^{b1}$, $R^{b1}$, $R^{b2}$, $R^{b3}$ and $R^{b4}$ of Chemical Formula 5-2.

In another example, in Chemical Formula 5-2, $L^{b1}$ may be a divalent to hexavalent organic group from which the hydroxyl groups have been removed from the polyol as the hydroxyl groups of the polyol having 2 to 6 hydroxyl groups are substituted with $Z^{b1}$ and $Z^{b2}$.

In Chemical Formula 5-2, the $L^{b1}$ may be, for example, a divalent organic group in which the hydroxy groups have been removed from a diol such as ethanediol, propanediol, or butanediol; a trivalent organic group in which the hydroxy groups have been removed from a triol such as glycerol or trimethylolpropane; a tetravalent organic group in which the hydroxy groups have been removed from tetraol such as pentaerythritol or ditrimethylolpropane; a pentavalent organic group in which the hydroxy groups have been removed from pentaol, such as 6-methylheptanepentaol; or a hexavalent organic group in which the hydroxy groups have been removed from hexaol such as dipentaerythritol.

In Chemical Formula 5-2, when $L^{b1}$ is a single bond or a divalent organic group, nb and mb are each 1. If the $L^{b1}$ is a trivalent to hexavalent organic group, nb may be larger than mb. In one example, the nb may be an integer of 1 to 3, and mb may be an integer of 1.

In one example, the $L^{b1}$ may be a trivalent organic group in which the hydroxy groups have been removed from glycerol which is a triol. And, nb may be 2, and mb may be 1. In such a case, the fluorinated compound represented by Chemical Formula 5-2 may be represented by the following Chemical Formula 5-2-b.

[Chemical Formula 5-2-b]

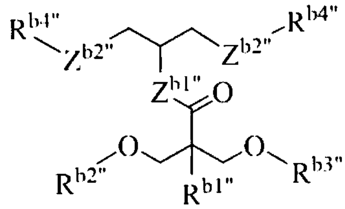

in Chemical Formula 5-2-b,

$Z^{b1''}$, $Z^{b2''}$, $R^{b1''}$, $R^{b2''}$, $R^{b3''}$ and $R^{b4''}$ are the same as $Z^{b1}$, $Z^{b2}$, $R^{b1}$, $R^{b2}$, $R^{b3}$ and $R^{b4}$ of Chemical Formula 5-2, respectively. The $Z^{b1''}$, $Z^{b2''}$, $R^{b1''}$, $R^{b2''}$, $R^{b3''}$ and $R^{b4''}$ may be substituents described herein as specific examples of $Z^{b1}$, $Z^{b2}$, $R^{b1}$, $R^{b2}$, $R^{b3}$ and $R^{b4}$ of Chemical Formula 5-2.

In Chemical Formula 5-2, at least one of $R^{b2}$ to $R^{b4}$ is a fluorine-containing substituent. The fluorine-containing substituent may be an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines. Specifically, the fluorine-containing substituent may be a straight chain alkyl group having 1 to 20 carbon atoms substituted with 2 or more fluorines. More specifically, the fluorine-containing substituent may be $-(CH_2)_a(CF_2)_bCHF_2$ or $-(CH_2)_a(CF_2)_bCF_3$. Wherein a is an integer of 0 to 3, an integer of 0 to 2, or an integer of 1, and b may be an integer of 0 to 19, an integer of 0 to 15, an integer of 0 to 12, an integer of 0 to 11, an integer of 0 to 10, or an integer of 0 to 9.

When $R^{b2}$ and $R^{b3}$ in Chemical Formula 5-2 are not fluorine-containing substituents, $R^{b2}$ and $R^{b3}$ may be each

independently hydrogen, an alkyl group having 1 to 20 carbon atoms, a cycloalkyl group having 3 to 30 carbon atoms, a heterocycloalkyl group having 4 to 30 carbon atoms, a cycloalkylalkyl group having 7 to 40 carbon atoms, an aryl group having 6 to 30 carbon atoms, a heteroaryl group having 4 to 30 carbon atoms, or an arylalkyl group having 7 to 40 carbon atoms, or may be substituents in which at least one $-CH_2-$ of the above substituents has been substituted with -O-, -S-, or -NH-.

Specifically, when $R^{b2}$ and $R^{b3}$ in Chemical Formula 5-2 are not fluorine-containing substituents, $R^{b2}$ and $R^{b3}$ may be each independently hydrogen, a straight chain alkyl group having 1 to 6 carbon atoms, a cycloalkyl group having 3 to 10 carbon atoms, a heterocycloalkyl group having 4 to 12 carbon atoms, an aryl group having 6 to 14 carbon atoms or $-(R^5-O)_p-R^6$. In the - $(R^5-O)_p-R^6$, $R^5$ is an alkylene group having 1 to 6 carbon atoms, $R^6$ is an alkyl group having 1 to 6 carbon atoms, and p may be an integer of 1 to 12.

More specifically, when $R^{b2}$ and $R^{b3}$ in Chemical Formula 5-2 are not fluorine-containing substituents, $R^{b2}$ and $R^{b3}$ are each independently hydrogen, a methyl group, an ethyl group, a propyl group, a butyl group, a cyclohexyl group, a tetrahydropyranyl group, a phenyl group or - $(R^5-O)_p-R^6$. Wherein, the $R^5$ may be a methylene group, an ethylene group, an n-propylene group, or an n-butylene group, particularly, a methylene group or an ethylene group. The $R^6$ may be a methyl group, an ethyl group, an n-propyl group, or an n-butyl group, particularly, a methyl group. The p may be, for example, an integer of 1 to 12, an integer of 1 to 10, an integer of 1 to 8, an integer of 1 to 6, an integer of 1 to 5, an integer of 1 to 4, or an integer of 1 to 3.

When $R^{b4}$ in Chemical Formula 5-2 is not a fluorine-containing substituent, $R^{b4}$ may be an alkyl group having 2 to 20 carbon atoms, a cycloalkyl group having 3 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or may be a substituent in which at least one $-CH_2-$ of the above substituents has been substituted with -O-, -S- or -NH-.

Specifically, when $R^{b4}$ in Chemical Formula 5-2 is not a fluorine-containing substituent, $R^{b4}$ may be a straight chain alkyl group having 2 to 6 carbon atoms, a cycloalkyl group having 3 to 10 carbon atoms, an aryl group having 6 to 14 carbon atoms or $-(R^5-O)_p-R^6$. In the $-(R^5-O)_p-R^6$, $R^5$ is an alkylene group having 1 to 6 carbon atoms, $R^6$ is an alkyl group having 1 to 6 carbon atoms, and p may be an integer of 1 to 12.

More specifically, when $R^{b4}$ in Chemical Formula 5-2 is not a fluorine-containing substituent, $R^{b4}$ may be $-(R^5-O)_p-R^6$. Wherein, the $R^5$ may be a methylene group, an ethylene group, an n-propylene group, or an n-butylene group, particularly, a methylene group or an ethylene group. The $R^6$ may be a methyl group, an ethyl group, an n-propyl group, or an n-butyl group, particularly, methyl group. The p may be, for example, an integer of 1 to 12, an integer of 1 to 10, an integer of 1 to 8, an integer of 1 to 6, an integer of 1 to 5, an integer of 1 to 4, or an integer of 1 to 3.

Meanwhile, in yet another example, the plasticizer may include a fluorinated compound represented by the following Chemical Formula 5-3.

[Chemical Formula 5-3]

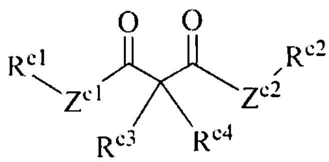

in Chemical Formula 5-3,

$Z^{c1}$ and $z^{c2}$ are each independently -O-, -S-, or -NH-,
at least one of $R^{c1}$ to $R^{c4}$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines,
when $R^{c1}$ to $R^{c4}$ are not fluorine-containing substituents, they are each independently an alkyl group having 1 to 20 carbon atoms, a cycloalkyl group having 3 to 30 carbon atoms, a heterocycloalkyl group having 4 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or are substituents in which at least one $-CH_2-$of the above substituents is substituted with -O-, -S- or -NH-.

In Chemical Formula 5-3, at least one of $R^{c1}$ to $R^{c4}$ is a fluorine-containing substituent. In one example, the $R^{c1}$ may be a fluorine-containing substituent.

The fluorine-containing substituent may be an alkyl group having 1 to 20 carbon atoms substituted with 2 or more

fluorines, a cycloalkyl group having 3 to 30 carbon atoms substituted with 2 or more fluorines, or an aryl group having 6 to 30 carbon atoms substituted with 2 or more fluorines.

Specifically, the fluorine-containing substituent may be a straight chain alkyl group having 1 to 20 carbon atoms substituted with 2 or more fluorines, a cycloalkyl group having 3 to 12 carbon atoms substituted with 2 or more fluorines, or an aryl group having 6 to 14 carbon atoms substituted with 2 or more fluorines.

More specifically, the fluorine-containing substituent may be $-(CH_2)_a(CF_2)_bCHF_2$, $-(CH_2)_a(CF_2)_bCF_3$, a decafluorocyclohexyl group, or a pentafluorophenyl group. Wherein, a is an integer of 0 to 3, an integer of 0 to 2, or an integer of 0 to 1, and b is an integer of 0 to 19, an integer of 0 to 15, an integer of 0 to 14, an integer of 0 to 13, an integer of 0 to 12, or an integer of 0 to 11.

In one example, when the fluorine-containing substituent may be $-(CH_2)_a(CF_2)_bCHF_2$, $-(CH_2)_a(CF_2)_bCF_3$, or a decafluorocyclohexyl group, it is possible to provide a hologram recording medium having low haze while contributing to increasing refractive index modulation.

When $R^{c1}$ to $R^{c4}$ in Chemical Formula 5-3 are not fluorine-containing substituents, $R^{c1}$ to $R^{c4}$ are each independently an alkyl group having 1 to 20 carbon atoms, a cycloalkyl group having 3 to 30 carbon atoms, a heterocycloalkyl group having 4 to 30 carbon atoms, a cycloalkylalkyl group having 7 to 40 carbon atoms, an aryl group having 6 to 30 carbon atoms, a heteroaryl group having 4 to 30 carbon atoms, or an arylalkyl group having 7 to 40 carbon atoms, or may be substituents in which at least one $-CH_2-$ of the above substituents has been substituted with -O-, - S-, or -NH-.

Specifically, when $R^{c1}$ to $R^{c4}$ in Chemical Formula 5-3 are not fluorine-containing substituents, $R^{c1}$ to $R^{c4}$ may be each independently a straight chain alkyl group having 1 to 6 carbon atoms, a cycloalkyl group having 3 to 10 carbon atoms, a heterocycloalkyl group having 4 to 12 carbon atoms, an aryl group having 6 to 14 carbon atoms, a heteroaryl group having 4 to 12 carbon atoms, an arylalkyl group having 7 to 16 carbon atoms, or $-(R^5-Y^1)_c-R^6$. In the $-(R^5-Y^1)_c-R^6$, $R^5$ is an alkylene group having 1 to 6 carbon atoms, $R^6$ is an alkyl group having 1 to 6 carbon atoms, a cycloalkyl group having 3 to 12 carbon atoms or an aryl group having 6 to 14 carbon atoms, $Y^1$ is -O- or -S-, and c may be an integer of 1 to 12, with the proviso that when c is 2 or more, $R^5$ may be the same or different from each other.

More specifically, when $R^{c1}$ to $R^{c4}$ in Chemical Formula 5-3 are not fluorine-containing substituents, $R^{c1}$ to $R^{c4}$ are each independently an ethyl group, a propyl group, a butyl group, a pentyl group, a hexyl group, a phenyl group, a benzyl group, a pyridinyl group, a pyrimidinyl group, a methoxymethyl group, a methoxyethyl group, a methylmercaptoethyl group, a methylaminoethyl group, $-(CH_2CH_2O)_{d1}CH_3$, $-CH_2O(CH_2CH_2O)_{d2}CH_3$, a cyclohexyloxyethyl group, a cyclohexyl mercaptoethyl group or a phenyloxyethyl group. Wherein, d1 is an integer of 1 to 5, and d2 is an integer of 1 to 4.

The photopolymer composition according to one embodiment of the disclosure may include at least one selected from the group consisting of fluorinated compounds represented by Chemical Formulas 5-1 to 5-3 as the plasticizer.

The photopolymer composition according to one embodiment of the disclosure may include the plasticizer in an amount of 20 to 200 parts by weight based on 100 parts by weight of the polymer matrix. Specifically, the lower limit of the content of the plasticizer may be, for example, 20 parts by weight or more, 25 parts by weight or more, 30 parts by weight or more, 35 parts by weight or more, 40 parts by weight or more, 45 parts by weight or more, 50 parts by weight or more, or 55 parts by weight or more, and the upper limit thereof may be, for example, 200 parts by weight or less, 180 parts by weight or less, 150 parts by weight or less, 140 parts by weight or less, or 130 parts by weight or less. When the above range is satisfied, it can represent large refractive index modulation values after recording due to the plasticizer having sufficient low refractive index, without problems of deteriorating the compatibility with the components contained in the photopolymer composition, of eluting some plasticizer to the surface of the photopolymer layer, or of degrading haze, which are advantageous for ensuring excellent optical recording properties.

The photopolymer composition of one embodiment may further include additives such as a surfactant or an antifoaming agent.

The photopolymer composition may include a silicone-based surfactant, a fluorine-based surfactant, or a mixture thereof as a surfactant.

As the silicone-based surfactant, for example, BYK-077, BYK-085, BYK-300, BYK-301, BYK-302, BYK-306, BYK-307, BYK-310, BYK-320, BYK-322, BYK-323, BYK-325, BYK-330, BYK-331, BYK-333, BYK-335, BYK-341v344, BYK-345v346, BYK-348, BYK-354, BYK355, BYK-356, BYK-358, BYK-361, BYK-370, BYK-371, BYK-375, BYK-380, BYK-390, BYK-3550 (manufactured by BYK Chemie), and the like may be used. As the fluorine-based surfactant, F-114, F-177, F-410, F-411, F-450, F-493, F-494, F-443, F-444, F-445, F-446, F-470, F-471, F-472SF, F-474, F-475, F-477, F-478, F-479, F-480SF, F-482, F-483, F-484, F-486, F-487, F-172D, MCF-350SF, TF-1025SF, TF-1117SF, TF-1026SF, TF-1128, TF-1127, TF1129, TF-1126, TF-1130, TF-1116SF, TF-1131, TF1132, TF1027SF, TF-1441, TF-1442 (manufactured by DaiNippon Ink & Chemicals), and the like may be used.

If the photopolymer composition of one embodiment includes a surfactant, the surfactant may be contained in an amount of 0.01 parts by weight or more, 0.02 parts by weight or more, 0.03 parts by weight or more, or 0.05 parts by weight or more, and 5 parts by weight or less, or 3 parts by weight or less, based on 100 parts by weight of the polymer matrix. When the above range is satisfied, it can impart excellent adhesion and release properties to the photopolymer layer, and

thus preserve excellent optical recording characteristics.

The photopolymer composition of one embodiment may include a silicone-based reactive additive as an antifoaming agent. As the silicone-based reactive additive, for example, commercially available products such as Tego Rad 2500 may be used. The content of the antifoaming agent can be appropriately adjusted at a level that does not impede the function of the hologram recording medium.

The photopolymer composition of one embodiment may further include a solvent.

The solvent may be an organic solvent, and an example thereof may be at least one organic solvent selected from the group consisting of ketones, alcohols, acetates, and ethers, but is not limited thereto. Specific examples of such organic solvents include at least one selected from the group consisting of ketones such as methyl ethyl ketone, methyl isobutyl ketone, acetylacetone, or isobutyl ketone; alcohols such as methanol, ethanol, n-propanol, i-propanol, n-butanol, i-butanol, or t-butanol; acetates such as ethyl acetate, i-propyl acetate, or polyethylene glycol monomethyl ether acetate; and ethers such as tetrahydrofuran or propylene glycol monomethyl ether.

The organic solvent may be added at the time point when respective components contained in the photopolymer composition are mixed, or may be included in the photopolymer composition while respective components are added in a state of being dispersed or mixed in an organic solvent.

The photopolymer composition of one embodiment may include a solvent such that the solid content concentration is 1 to 90% by weight. Specifically, the photopolymer composition may include a solvent such that the solid concentration is 20% by weight or more, or 30% by weight or more, and 85% by weight or less, 80% by weight or less, 75% by weight or less, or 70% by weight or less. Within this range, the photopolymer composition exhibits appropriate flowability and can form a coating layer without defects such as stripes. No defects occur during the drying and curing process and thus, a photopolymer layer exhibiting desired physical properties and surface properties can be formed.

On the other hand, according to another embodiment of the disclosure, there is provided a photopolymer composition comprising: a polymer matrix or a precursor thereof; a photoreactive monomer; a photosensitizing dye; and a co-initiator, wherein the photosensitizing dye comprises a compound represented by the following Chemical Formula 1-1.

[Chemical Formula 1-1]

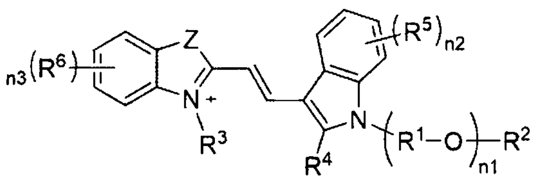

in Chemical Formula 1-1,

$R^1$ is an alkylene group having 1 to 6 carbon atoms, $R^2$ is an alkyl group having 1 to 6 carbon atoms,
n1 is an integer of 1 to 6,
$R^3$ is an alkyl group having 3 to 12 carbon atoms,
$R^4$ is hydrogen or an alkyl group having 1 to 6 carbon atoms,
$R^5$ and $R^6$ are each independently a halogen, a hydroxyl group, an alkyl group having 1 to 6 carbon atoms, or an alkoxy group having 1 to 6 carbon atoms,
n2 and n3 are each independently an integer of 0 to 4,
Z is oxygen, sulfur, or $CR^7R^8$,
$R^7$ and $R^8$ are each independently an alkyl group having 1 to 6 carbon atoms.

The photopolymer composition of another embodiment may include the same components as the photopolymer composition of one embodiment except that it includes the compound represented by the above Chemical Formula 1-1 instead of the compound including the core represented by Chemical Formula 1, and having an openness of 7.0 to 8.5 Å$^2$ for the double bond connecting two hetero rings.

Since the polymer matrix or a precursor thereof; the photoreactive monomer; the photosensitizing dye including the compound represented by Chemical Formula 1-1 and the co-initiator contained in the photopolymer composition of another embodiment have been described in detail previously, a detailed description will be omitted here. The photopolymer composition of another embodiment may further include any optional component(s) of the photopolymer composition of one embodiment as described above.

On the other hand, according to yet another embodiment of the disclosure, there is provided a hologram recording medium including a photopolymer layer formed from the photopolymer composition.

The photopolymer composition may be the photopolymer composition of one embodiment or the photopolymer

composition of another embodiment. Since its components have been described in detail previously, a detailed description will be omitted here.

The hologram recording medium of yet another embodiment may further include a substrate on at least one surface of the photopolymer layer. The type of the substrate is not particularly limited, and those known in the related technical field may be used. For example, substrates such as glass, PET (polyethylene terephthalate), TAC (triacetyl cellulose), PC (polycarbonate), or COP (cycloolefin polymer) may be used.

Since the photopolymer layer is formed from the photopolymer composition, it can achieve excellent refractive index modulation and high diffraction efficiency despite having a thin thickness, thereby providing excellent optical recording characteristics and showing outstanding reliability even under high temperature conditions.

The thickness of the photopolymer layer may be, for example, in the range of 5.0 to 40.0 μm. Specifically, the lower limit of the thickness of the photopolymer layer may be, for example, 6 μm or more, 7 μm or more, 8 μm or more, or 9 μm or more. And, the upper limit of the thickness may be, for example, 35 μm or less, 30 μm or less, 29 μm or less, 28 μm or less, 27 μm or less, 26 μm or less, 25 μm or less, 24 μm or less, 23 μm or less, 22 μm or less, 21 μm or less, 20 μm or less, 19 μm or less, or 18 μm or less.

The hologram recording medium of yet another embodiment can realize a refractive index modulation value (Δn) of 0.020 or more, 0.025 or more, 0.026 or more, 0.027 or more, 0.028 or more, 0.029 or more, 0.030 or more, 0.031 or more, 0.032 or more, 0.033 or more, 0.034 or more, or 0.035 or more even if the thickness of the photopolymer layer is as thin as 5 to 30 μm. The upper limit of the refractive index modulation value is not particularly limited, but may be, for example, 0.060 or less.

The hologram recording medium of yet another embodiment is not limited thereto, but may be a medium on which a reflective hologram or a transmissive hologram is recorded.

The hologram recording medium may have a notch filter structure in relation to the diffraction grating structure. The hologram recording medium of yet another embodiment having a notch filter structure may mean that the diffraction grating is non-slanted (substantially 0°) with respect to the substrate surface, for example, as if the diffraction grating is parallel to the substrate surface. Such a hologram recording medium may have a structure in which two layers having different refractive indexes (e.g., a high refractive index layer and a low refractive index layer) are alternately repeated. Further, the two repeated layers may respectively have a predetermined thickness that is the same or different from each other. Such a non-slanted diffraction grating record can be prepared in such a way that the incident angles of the incident object light and reference light are made equal based on the normal line. In the non-slanted structure, the degree of deformation (e.g., shrinkage or expansion) under high temperature and high humidity conditions is further clearly confirmed compared to the slanted structure, and it is less affected by the shrinkage and expansion of the substrate.

The hologram recording medium of yet another embodiment can have high diffraction efficiency. In one example, the hologram recording medium may have a diffraction efficiency of 70% or more upon recording a notch filter hologram. Wherein, the thickness of the photopolymer layer may be, for example, 5 to 30 μm. Specifically, when recording the notch filter hologram, the diffraction efficiency may be 71% or more, 75% or more, 80% or more, 85% or more, 86% or more, 87% or more, 88% or more, 89% or more, 90% or more, 91% or more, 92% or more, 93% or more, or 94% or more. In this manner, the hologram recording medium of yet another embodiment can realize excellent diffraction efficiency even if it includes a photopolymer layer of thin thickness. The diffraction efficiency may be measured by the method described in the Test Example described below.

Since the hologram recording medium of yet another embodiment includes the compound including the core represented by Chemical Formula 1 and having an openness of 7.0 to 8.5 Å$^2$ for double bond connecting two hetero rings (or the compound represented by Chemical Formula 1-1), it is possible to enable optical recording in the blue region and can exhibit excellent thermal stability. In particular, since the hologram recording medium of yet another embodiment has excellent thermal stability before recording, even if exposed to high temperature conditions before recording it still retains excellent optical recording characteristics.

In one example, the hologram recording medium of yet another embodiment may exhibit a retention rate of diffraction efficiency of 90% or more, 95% or more, 96% or more, 97% or more, 98% or more, or 99% or more when the hologram recording medium before recording is stored under high temperature of 60°C for 20 days and then a notch filter hologram is recorded. The "retention rate of diffraction efficiency after high temperature storage" refers to the percentage of the diffraction efficiency measured after recording a notch filter hologram on a hologram recording medium stored under high temperatures before recording, compared to the initial diffraction efficiency measured after recording a notch filter hologram on a hologram recording medium not stored under high temperatures before recording. The retention rate of diffraction efficiency may be measured by the method described in the Test Example described below.

Since the diffraction efficiency after high temperature storage may sometimes exceed that before high temperature storage, the upper limit of the retention rate of diffraction efficiency may exceed 100%. The upper limit of the retention rate of diffraction efficiency is not particularly limited, but may be, for example, 110% or less, 105% or less, or 102% or less.

In another example, the hologram recording medium of yet another embodiment may exhibit a retention rate of

diffraction efficiency of 90% or more, 91% or more, 92% or more, 93% or more, 94% or more, or 95% or more when the hologram recording medium before recording is stored under high temperature of 60°C for 30 days and then a notch filter hologram is recorded. The upper limit of the retention rate of diffraction efficiency after being stored under high temperatures of 60°C for 30 days is not particularly limited, but may be, for example, 105% or less, or 102% or less.

Conventionally developed hologram recording media for optical recording in the blue region often exhibit an opaque color compared to those for the red or green regions, i.e., they show a high color difference (ΔE).

However, since the hologram recording medium of yet another embodiment includes the compound including the core represented by Chemical Formula 1 and having an openness of 7.0 to 8.5 $Å^2$ for double bond connecting two hetero rings (or the compound represented by Chemical Formula 1-1), it is possible to enable optical recording in the blue region and exhibit colorless and transparent optical properties.

In one example, if the hologram recording medium is in an unrecorded state and subjected to photobleaching, the color difference (ΔE) relative to white light of the same brightness may be 3.0 or less. The ΔE may be measured by the method described in the Test Example described below. A small ΔE indicates that the medium transmits the three primary colors (red, green, and blue) in a balanced manner, so the color of an image observed through the hologram recording medium closely matches the actual color (the originally intended color).

The hologram recording medium of yet another embodiment may have, for example, △E of 3.0 or less, 2.9 or less, 2.8 or less, 2.7 or less, 2.6 or less, 2.5 or less, 2.4 or less, 2.3 or less, 2.2 or less, 2.1 or less, 2.0 or less, or 1.9 or less. The lower limit of the ΔE is not particularly limited, but may be, for example, 0 or more.

The hologram recording medium of yet another embodiment can exhibit colorless and transparent optical properties by removing color of a photosensitizing dye through a photobleaching step after recoding optical information. Therefore, the hologram recording medium of yet another embodiment can exhibit high transmittance in the blue region after recoding. In one example, the hologram recording medium of yet another embodiment may have an average transmittance in the 400 nm to 430 nm range of 80% or more, 81% or more, 82% or more, 83% or more, 84% or more, or 85% or more, after recording optical information. The upper limit of the average transmittance is not particularly limited, but may be, for example, 100% or less, or 95% or less. The average transmittance in the 400 nm to 430 nm range is an average value obtained by measuring the transmittance in the 400 nm to 430 nm range using a UV-Vis spectrometer.

The use of the hologram recording medium of yet another embodiment is not particularly limited. By way of non-limiting example, the hologram recording medium may be used in applications likely to be exposed to high temperature environments, specifically, smart devices such as mobile devices, parts of wearable displays, vehicle articles (e.g., head up display) and the like.

On the other hand, according to a further embodiment of the disclosure, there is provided a method for preparing a hologram recording medium, comprising a step of applying a photopolymer composition to form a photopolymer layer.

The photopolymer composition may be the photopolymer composition of one embodiment or the photopolymer composition of another embodiment. Since its components have been described in detail previously, a detailed description will be omitted here.

In the step of forming the photopolymer layer, a photopolymer composition containing the above-mentioned configuration may first be prepared. When preparing the photopolymer composition, for mixing each component, a commonly known blender, stirrer, mixer or the like may be used without particular restriction. Further, such a mixing process may be performed at a temperature ranging from 0°C to 100°C, a temperature ranging from 10°C to 80°C, or a temperature ranging from 20°C to 60°C.

In the step of forming the photopolymer layer, the prepared photopolymer composition may be applied to form a coating layer formed from the photopolymer composition. The coating layer may be dried naturally at room temperature or dried at a temperature of 30°C to 80°C. Through this process, a hydrosilylation reaction between the hydroxyl group of the acrylic-based polyol remaining unreacted and the silane functional group of the siloxane-based polymer may be induced.

In the photopolymer layer prepared through the step of forming the photopolymer layer, a photoreactive monomer, a photosensitizing dye, a co-initiator, and additives added as necessary may be uniformly dispersed within the crosslinked polymer matrix.

The method for preparing the hologram recording medium according to a further embodiment may further include a step of recording optical information by irradiating a coherent laser onto a predetermined region of the photopolymer layer and selectively polymerizing the photoreactive monomer contained in the photopolymer layer after the step of forming the photopolymer layer.

In the step of recording optical information, if a coherent laser is irradiated onto the photopolymer layer, polymerization of photoreactive monomers occurs to form a photopolymer in the constructive interference region, and polymerization of photoreactive monomer does not occur or is suppressed in the destructive interference region, so that the photoreactive monomer are present. Further, while the unreacted photoreactive monomer causes refractive index modulation while diffusion occurs toward the photopolymer side where the concentration of photoreactive monomers is lower, and a diffraction grating is produced by the refractive index modulation. Thereby, holograms, i.e. optical information, are recorded on the photopolymer layer having the diffraction grating.

The method for preparing the hologram recording medium according to a further embodiment may further include a step of photobleaching by irradiating light onto the entire photopolymer layer on which the optical information is recorded after the step of recording the optical information.

In the photobleaching step, ultraviolet rays are irradiated onto the photopolymer layer on which optical information is recorded to terminate the reaction of the photoreactive monomer remaining in the photopolymer layer and remove the color of the photosensitizing dye. In one example, in the photobleaching step, ultraviolet rays (UVA) in the range of 320 to 400 nm are irradiated to terminate the reaction of the photoreactive monomer and remove the color of the photosensitizing dye.

On the other hand, according to a further embodiment of the disclosure, there is provided an optical element comprising the hologram recording medium.

Specific examples of the optical elements may include smart devices such as mobile devices, parts of wearable displays, vehicle articles (e.g., head up display), holographic fingerprint recognition system, optical lenses, mirrors, deflecting mirrors, filters, diffusing screens, diffraction elements, light guides, waveguides, holographic optical elements having projection screen and/or mask functions, medium of optical memory system and light diffusion plate, optical wavelength multiplexers, reflection type, transmission type color filters, and the like.

An example of an optical element including the hologram recoding medium may include a hologram display device. The hologram display device includes a light source unit, an input unit, an optical system, and a display unit.

Specifically, the light source unit is a portion that irradiates a laser beam used for providing, recording, and reproducing three-dimensional image information of an object in the input unit and the display unit.

The input unit is a portion that previously inputs three-dimensional image information of an object to be recorded on the display unit, specifically, a portion in which three-dimensional information of an object such as the intensity and phase of light for each space may be inputted into an electrically addressed liquid crystal SLM, wherein an input beam may be used.

The optical system may include a mirror, a polarizer, a beam splitter, a beam shutter, a lens, and the like. The optical system may be distributed into an input beam for sending a laser beam emitted from the light source unit to the input unit, a recording beam for sending the laser beam to the display unit, a reference beam, an erasing beam, a reading beam, and the like.

The display unit may receive three-dimensional image information of an object from an input unit, record it on a hologram plate comprising an optically addressed SLM, and reproduce the three-dimensional image of the object. At this time, the three-dimensional image information of the object may be recorded via interference of the input beam and the reference beam. The three-dimensional image information of the object recorded on the hologram plate may be reproduced into a three-dimensional image by the diffraction pattern generated by the reading beam. The erasing beam may be used to quickly remove the formed diffraction pattern. On the other hand, the hologram plate may be moved between a position at which a three-dimensional image is inputted and a position at which a three-dimensional image is reproduced.

## [ADVANTAGEOUS EFFECTS]

According to one embodiment of the disclosure, the photopolymer composition is able to provide a hologram recording medium and an optical element comprising the same, which exhibit excellent optical recording characteristics such as diffraction efficiency, while securing colorless and transparent optical properties along with superior thermal stability.

## [BRIEF DESCRIPTION OF THE DRAWINGS]

FIG. 1 schematically shows the recording equipment setup for hologram recording. Specifically, FIG. 1 schematically shows the process in which a laser of a predetermined wavelength is radiated from the light source 10, and irradiated onto the PP (hologram recording medium) 80 located on one surface of a mirror 70 via mirrors 20 and 20’, an iris 30, a spatial filter 40, an iris 30’, a collimation lens 50, and PBS (Polarized Beam Splitter) 60.

## [DETAILED DESCRIPTION OF THE EMBODIMENTS]

Hereinafter, the action and effect of the invention will be described in more detail with reference to specific examples of the invention. However, these examples are presented for illustrative purposes only, and the scope of the invention is not limited thereby in any way.

In the following Preparation Examples, Examples, Comparative Examples, and the like, the content of raw materials, and the like means the content based on solid content, unless otherwise specified.

**Preparation Example 1: Preparation of acrylic-based polyol**

132 g of butyl acrylate, 420 g of ethyl acrylate, and 48 g of hydroxybutyl acrylate were added to a 2 L jacketed reactor, and diluted with 1200 g of ethyl acetate. The reaction temperature was set to 60~70°C, and the mixture was stirred for about 30 minutes to 1 hour. 0.42 g of n-dodecyl mercaptan (n-DDM) was further added, and stirring was further performed for about 30 minutes. Then, 0.24 g of AIBN as a polymerization initiator was added, polymerization was performed at the reaction temperature for 4 hours or more, and kept until the residual acrylate content became less than 1%. Thereby, an acrylate-based copolymer (weight average molecular weight of about 300,000, OH equivalent of about 1802 g/equivalent) in which the hydroxy group was located in the branched chain was prepared.

**Example 1: Preparation of photopolymer composition and hologram recording medium**

(1) Preparation of photopolymer composition

First, 1.65 g of poly(methylhydrosiloxane) (Sigma-Aldrich, number average molecular weight: about 390, Si-H equivalent: about 103 g/equivalent) as a siloxane-based polymer and 33.4 g of the acrylic-based polyol (solid content: 10.02 g) prepared in Preparation Example 1 (solid content: 30 wt%) were mixed (SiH/OH molar ratio = 2.83).

Then, 17.2 g of HR 6042 (Miwon Specialty Chemical, refractive index of 1.60) and 3.3 g of O-phenylphenol (ethylene oxide) acrylate were added as a photoreactive monomer; 0.25 g of a compound represented by the following Chemical Formula A-1 (molecular weight: 749.86 g/mol) was added as a photosensitizing dye; 0.5 g of tetrabutylammonium tri(p-chloro-o-methylphenyl)butyl borate (molecular weight: 678.12 g/mol) and 0.45 g of hexadecyl dimethyl benzylammonium tri(p-chlorophenyl)butyl borate (molecular weight: 763.21 g/mol) were added as an electron donor (co-initiators); 0.02 g of 2-(4-methoxyphenyl)-4,6-bis(trichloromethyl)-1,3,5-triazine (TCI) was added as an electron acceptor (co-initiators); 0.5 g of Irgacure 819 was added as a photoinitiator; 13.5 g of a fluorinated compound represented by the following Chemical Formula B was added as a plasticizer; and 0.16 g of BYK-331 was added as an additive; and a mixed solvent (n-butanol, i-propanol, methyl isobutyl ketone, methyl ethyl ketone, and ethyl acetate in a weight ratio of 0.34 : 15.00 : 9.33 : 21.98 : 18.35) was added to prepare a 35 wt% solid content, and the mixture was stirred with a paste mixer for about 30 minutes while blocking light. After that, Karstedt (Pt-based) catalyst was added for matrix crosslinking to prepare a photopolymer composition.

About 4 mol of tetrabutylammonium tri(p-chloro-o-methylphenyl)butyl borate and hexadecyl dimethyl benzylammonium tri(p-chlorophenyl)butyl borate were used for each 1 mol of the compound represented by the following Chemical Formula A-1 below.

[Chemical Formula A-1]

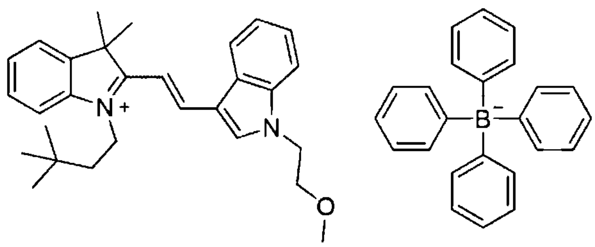

[Chemical Formula B]

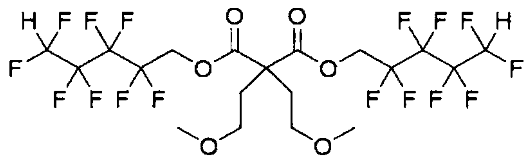

(2) Preparation of hologram recording medium

The photopolymer composition was coated to a predetermined thickness on a 60 $\mu$m thick TAC substrate using a Mayer bar, and dried at 80°C for 10 minutes. The thickness of the photopolymer layer after drying was about 14 $\mu$m.

**Example 2 and Comparative Examples 1 to 6: Preparation of photopolymer composition and hologram recording medium**

A photopolymer composition and a hologram recording medium were prepared in the same manner as in Example 1, except that the photosensitizing dye was changed as shown in Table 1 below.

<Calculation of the openness of the photosensitizing dye>

The term "openness of the photosensitizing dye" refers to the openness of the double bond that connects two hetero rings in the core commonly included in the photosensitizing dyes used in the Examples and Comparative Examples.
The openness of the double bond was determined by calculating the openness for each of the two carbon atoms forming the double bond and then adding the openness values of the two carbons.
The openness of each carbon atom is the open surface area not blocked by substituents with respect to the surface area of a sphere with a radius of 1.2 Å from the center of the carbon atom.
The openness was determined using Jmol software with a density functional theory (DFT) method using a quantum chemical calculation program (Gaussian 16 manufactured by Gaussian, Inc.) by applying the functional B3LYP with a 6-31G* basis set.

**[Table 1]**

| | Photosensitizing dye | Openness(Å$^2$) |
|---|---|---|
| Example 1 | [Chemical Formula A-1] 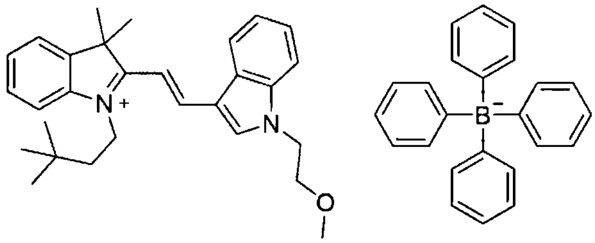 (molecular weight: 749.864 g/mol) | 8.41 |
| Example 2 | [Chemical Formula A-2] 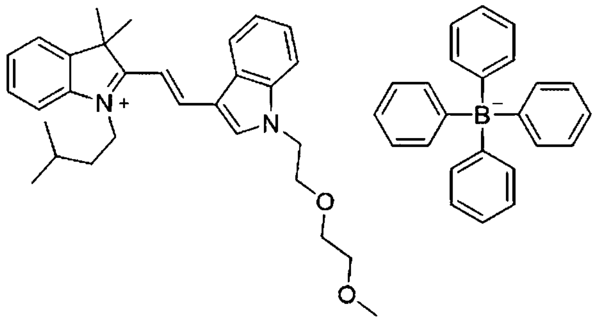 (molecular weight: 779.8902 g/mol) | 8.23 |
| Comparative Example 1 | [Chemical Formula C-1] 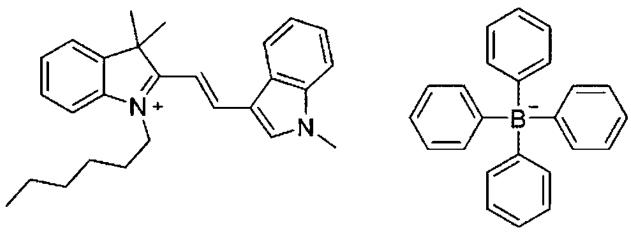 | 8.75 |

(continued)

| | Photosensitizing dye | Openness(Å²) |
|---|---|---|
| Comparative Example 2 | [Chemical Formula C-2]<br>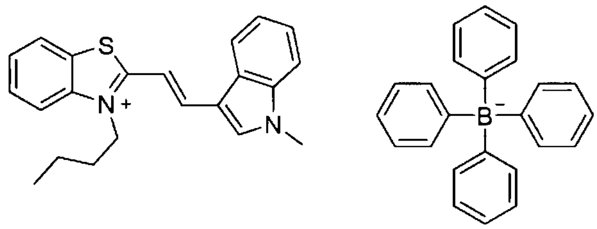 | 12.74 |
| Comparative Example 3 | [Chemical Formula C-3]<br>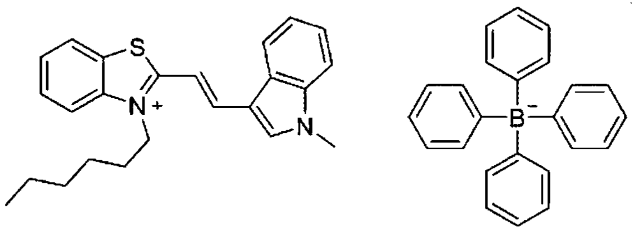 | 12.52 |
| Comparative Example 4 | [Chemical Formula C-4]<br>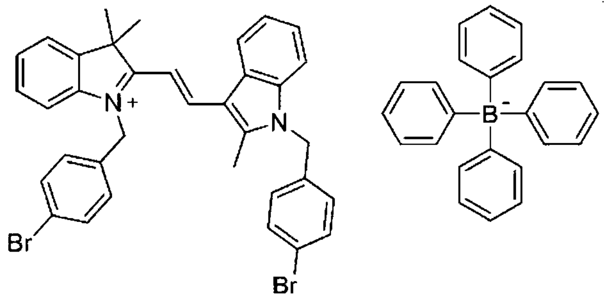 | 4.66 |
| Comparative Example 5 | [Chemical Formula C-5]<br>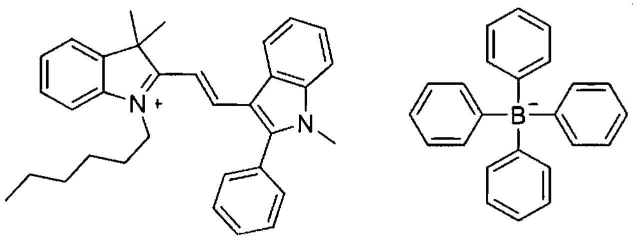 | 6.73 |
| Comparative Example 6 | [Chemical Formula C-6]<br>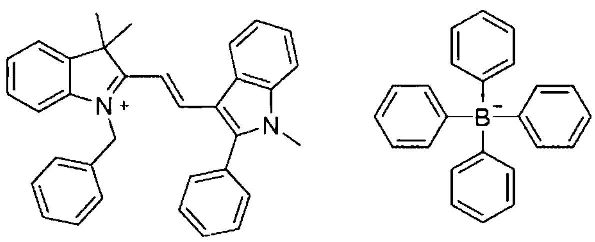 | 6.60 |

Test Example: Analysis of hologram recording medium

(1) Color difference (ΔE)

A sample of the hologram recording medium (hereinafter referred to as a "sample before recording"), on which no optical information had been recorded, was subjected to ultraviolet (UV) and white LED irradiation to obtain a photobleached sample. The transmittance of the photobleached sample in the visible range (wavelengths from 400 to 700 nm) was measured using a UV-Vis spectrophotometer to obtain a transmission spectrum. The tristimulus values (X, Y, Z) in the CIE XYZ color space were calculated from the transmission spectrum of the photobleached sample. The tristimulus values were calculated according to the following Equation 1.

[Equation 1]

$$X = k\int_{400}^{700} S(\lambda)\bar{x}(\lambda)\boldsymbol{\tau}(\lambda)\,d\lambda$$
$$Y = k\int_{400}^{700} S(\lambda)\bar{y}(\lambda)\boldsymbol{\tau}(\lambda)\,d\lambda$$
$$Z = k\int_{400}^{700} S(\lambda)\bar{z}(\lambda)\boldsymbol{\tau}(\lambda)\,d\lambda$$

$$k = \frac{100}{\int_{400}^{700} S(\lambda)\bar{y}(\lambda)\,d\lambda}$$

In Equation 1, S(λ) is the output distribution function of the standard illuminant (D65), $\bar{x}(\lambda),\bar{y}(\lambda),\bar{z}(\lambda)\cdot$ is the color correspondence function for a viewing angle of 10 ° in the CIE XYZ color space, $\tau(\lambda)$ is the transmittance distribution function (transmission spectrum) of the photobleached sample, and λ is wavelength.

The tristimulus values obtained from Equation 1 were converted into L*, a*, and b* values in the CIE Lab color space according to the following Equation 2.

[Equation 2]

$$L^* = 116\times f\left(\frac{Y}{Y_n}\right) - 16$$
$$a^* = 500\times f\left(\frac{X}{X_n}\right) - f\left(\frac{Y}{Y_n}\right)$$
$$b^* = 200\times f\left(\frac{Y}{Y_n}\right) - f\left(\frac{Z}{Z_n}\right)$$

$$f(t) = \begin{cases} t^{1/3} & ,(t > \left(\frac{24}{116}\right)^3) \\ \frac{1}{3}\left(\frac{29}{6}\right)^2 t + \frac{4}{29} & ,(t \le \left(\frac{24}{116}\right)^3) \end{cases}$$

In Equation 2, $X_n$, $Y_n$, and $Z_n$ are values of 94.71, 100.00, and 107.08, respectively, for the standard illuminant (D65) at a viewing angle of 10 °, and t is $X/X_n$, $Y/Y_n$, or $Z/Z_n$.

The L*, a*, and b* obtained from Equation 2 were substituted into the following Equation 3 to obtain the color difference (ΔE).

[Equation 3]

$$\Delta E = \sqrt{\Delta L^{*2} + \Delta a^{*2} + \Delta b^{*2}} = \sqrt{(L_S^* - L_R^*)^2 + (a_S^* - a_R^*)^2 + (b_S^* - b_R^*)^2}$$

In Equation 3, $L_S$*, $a_S$*, and $b_S$* are the L*, a*, and b* values of the test sample for which the color difference is to be measured, and $L_R$*, $a_R$*, and $b_R$* are the L*, a*, and b* values of the reference sample.

In this test example, the reference sample was assumed to be white light of the same brightness (L*) as the test sample, so $L_R$* was identical to Ls*, making the (Ls* - $L_R$*)$^2$ term in Equation 3 equal to 0, and $a_R$* and $b_R$* were also 0.

A small △E indicates that the hologram recording medium transmits the three primary colors (red, green, and blue) in a balanced manner without being biased to any one color, so the color of an image observed through the hologram recording medium closely matches the actual color (the originally intended color).

(2) Diffraction efficiency (DE)

A diffraction grating was recorded using the same setup as shown in FIG. 1. Specifically, when the prepared photopolymer layer was laminated on a mirror and then irradiated with a laser, a notch filter hologram with periodic refractive index modulation in the thickness direction could be recorded through interference between incident light (L) and light reflected from the mirror (L'). In this example, the notch filter hologram was recorded for 40 seconds at an incident angle of 0° (degree) using a 460 nm laser and a light intensity of 0.75 mW/cm$^2$. Notch filter and Bragg reflector are optical devices that reflect only light of a specific wavelength, and have a structure in which two layers with different refractive indices are stacked periodically and repeatedly at a constant thickness.

Diffraction efficiency ($\eta$) was determined through the following Equation 4 for the sample after recording.

[Equation 4]

$$\eta\,(\%) = \{P_D / (P_D + P_T)\} \text{ X } 100$$

in Equation 4, $\eta$ is the diffraction efficiency, $P_D$ is the output amount (mW/ cm$^2$) of the diffracted beam of the sample after recording, and $P_T$ is the output amount (mW/cm$^2$) of the transmitted beam of the sample after recording.

(3) High temperature stability before recording

In order to confirm the high temperature stability of the hologram recording medium before recording, the sample before recording was stored under high temperature, and its optical recording characteristics were compared before and after such storage.

Specifically, after storing the sample before recording at 60 °C for 20 days, a diffraction grating was recorded by the method described above, and the diffraction efficiency was obtained by Equation 4.

In addition, after storing the sample before recording at 60 °C for 30 days, a diffraction grating was recorded by the method described above, and the diffraction efficiency was obtained by Equation 4.

A retention rate of diffraction efficiency (DE retention rate) was calculated according to the following Equation 5, and is shown in Table 2 below.

[Equation 5]

$$\text{DE retention rate } (\%) = 100 \times (DE^b / DE^a)$$

In Equation 5, $DE^a$ is a diffraction efficiency of the sample before high-temperature storage, i.e., the initial diffraction efficiency measured after recording a diffraction grating on a sample not exposed to high temperature prior to recording, and

$DE^b$ is a diffraction efficiency of the sample after high-temperature storage, measured by recording a diffraction grating on a sample that was exposed to high temperature prior to recording.

**[Table 2]**

| | Color difference (△E) | initial DE (%) | High-temperature stability before recording | | | |
|---|---|---|---|---|---|---|
| | | | 60 °C for 20 days | | 60 °C for 30 days | |
| | | | DE (%) | DE retention rate (%) | DE (%) | DE retention rate (%) |
| Example 1 | 2.8 | 95.1 | 95.1 | 100 | 90.5 | 95.2 |
| Example 2 | 1.87 | 94.3 | 93.7 | 99.4 | 94.8 | 100.5 |
| Comparative Example 1 | 4.38 | 68.2 | 38.0 | 55.7 | 31.1 | 45.6 |
| Comparative Example 2 | 3.43 | 58.1 | 10.5 | 18.1 | - | - |
| Comparative Example 3 | 2.71 | 55.4 | 30.1 | 54.3 | 22.5 | 40.6 |
| Comparative Example 4 | 3.35 | 56.0 | 48.3 | 86.2 | 38.9 | 69.5 |
| Comparative Example 5 | 8.48 | 91.8 | 85.9 | 93.6 | 82.9 | 90.3 |

(continued)

| | Color difference (△E) | initial DE (%) | High-temperature stability before recording | | | |
|---|---|---|---|---|---|---|
| | | | 60 °C for 20 days | | 60 °C for 30 days | |
| | | | DE (%) | DE retention rate (%) | DE (%) | DE retention rate (%) |
| Comparative Example 6 | 5.4 | 66.0 | 43.6 | 66.1 | 36.0 | 54.5 |

Referring to Table 2, in the case of Comparative Examples 1 to 3 using photosensitizing dyes having an openness of the double bond exceeding 8.5 Å$^2$, it was confirmed that the thermal stability was poor and then the optical recording characteristics were significantly deteriorated when stored under high temperature. In particular, in the case of Comparative Example 2, which used the photosensitizing dye with the largest openness of double bonds, optical recording was impossible after storing it at 60°C for 30 days. In addition, Comparative Examples 1 to 3 showed high ΔE values and low diffraction efficiencies.

Meanwhile, in the case of Comparative Examples 4 to 6 using photosensitizing dyes having an openness of the double bond less than 7 Å$^2$, contrary to the prediction that they would show excellent thermal stability, they actually showed lower thermal stability compared to Examples 1 and 2 and exhibited higher ΔE values and lower diffraction efficiencies.

Hence, it was confirmed that the photopolymer composition according to one embodiment of the disclosure, by employing a photosensitizing dye whose double bond openness meets a particular value, can provide a hologram recording medium possessing colorless and transparent optical properties, excellent thermal stability, and outstanding optical recording characteristics such as high diffraction efficiency.

## Claims

**1.** A photopolymer composition comprising:

a polymer matrix or a precursor thereof;
a photoreactive monomer;
a photosensitizing dye; and
a co-initiator,
wherein the photosensitizing dye is a compound that includes a core represented by the following Chemical Formula 1, and has an openness of 7.0 to 8.5 Å$^2$ for the double bond connecting two hetero rings:

[Chemical Formula 1]

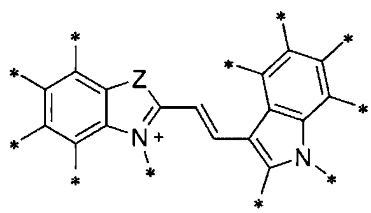

in Chemical Formula 1,

Z is oxygen, sulfur, or $CR^7R^8$
$R^7$ and $R^8$ are each independently an alkyl group having 1 to 6 carbon atoms.

**2.** The photopolymer composition according to claim 1, wherein the polymer matrix is formed by crosslinking a siloxane-based polymer containing a silane functional group and an acrylic-based polyol.

**3.** The photopolymer composition according to claim 1, wherein the photoreactive monomer comprises at least one monofunctional monomer selected from the group consisting of benzyl (meth)acrylate, benzyl 2-phenylacrylate, phenoxybenzyl (meth)acrylate, phenol (ethylene oxide) (meth)acrylate, phenol (ethylene oxide)$_2$ (meth)acrylate, O-phenylphenol (ethylene oxide) (meth)acrylate, phenylthioethyl (meth)acrylate and biphenylmethyl (meth)acrylate; at

least one polyfunctional monomer selected from the group consisting of bisphenol A (ethylene oxide)$_{2\sim10}$ di(meth)acrylate, bisphenol A epoxy di(meth)acrylate, bisfluorene di(meth)acrylate, modified bisphenol fluorene di(meth)acrylate, tris(2-hydroxyethyl)isocyanurate tri(meth)acrylate, phenol novolac epoxy (meth)acrylate and cresol novolac epoxy (meth)acrylate; or a mixture of two or more thereof.

**4.** The photopolymer composition according to claim 1, wherein the openness of the double bond is the sum of the openness values calculated separately for each of the two carbon atoms forming the double bond, and the openness of each carbon atom is the open surface area not blocked by substituents with respect to the surface area of a sphere with a radius of 1.2 Å from the center of the carbon atom, and determined using Jmol software with a density functional theory method using a quantum chemical calculation program, by applying the functional B3LYP with a 6-31G* basis set.

**5.** The photopolymer composition according to claim 1, wherein the compound including the core of Chemical Formula 1 and having an openness of 7.0 to 8.5 Å$^2$ for the double bond connecting two hetero rings is a compound represented by the following Chemical Formula 1-1:

[Chemical Formula 1-1]

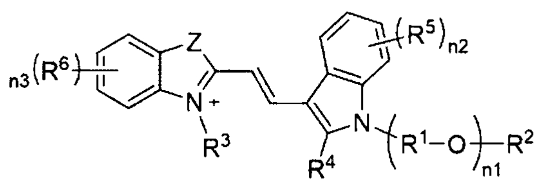

in Chemical Formula 1-1,

$R^1$ is an alkylene group having 1 to 6 carbon atoms, $R^2$ is an alkyl group having 1 to 6 carbon atoms,
n1 is an integer of 1 to 6,
$R^3$ is an alkyl group having 3 to 12 carbon atoms,
$R^4$ is hydrogen or an alkyl group having 1 to 6 carbon atoms,
$R^5$ and $R^6$ are each independently a halogen, a hydroxyl group, an alkyl group having 1 to 6 carbon atoms, or an alkoxy group having 1 to 6 carbon atoms,
n2 and n3 are each independently an integer of 0 to 4,
Z is oxygen, sulfur, or $CR^7R^8$,
$R^7$ and $R^8$ are each independently an alkyl group having 1 to 6 carbon atoms.

**6.** The photopolymer composition according to claim 1, wherein the photosensitizing dye further comprises a tetraaryl borate.

**7.** The photopolymer composition according to claim 1, wherein the co-initiator comprises a borate anion represented by the following Chemical Formula 4:

[Chemical Formula 4] $BX^1X^2X^{3\ 4}$

in Chemical Formula 4, $X^1$ to $X^4$ are each independently an alkyl group having 1 to 20 carbon atoms, an alkenyl group having 2 to 20 carbon atoms, an aryl group having 6 to 30 carbon atoms, an arylalkyl group having 7 to 30 carbon atoms, an alkylaryl group having 7 to 30 carbon atoms, or an allyl group, each of which is substituted or unsubstituted, with the proviso that at least one of $X^1$ to $X^4$ is not an aryl group.

**8.** The photopolymer composition according to claim 1, wherein the co-initiator comprises at least one borate anion selected from the group consisting of borate anions represented by the following Chemical Formulas 4-1 and 4-2:

[Chemical Formula 4-1]

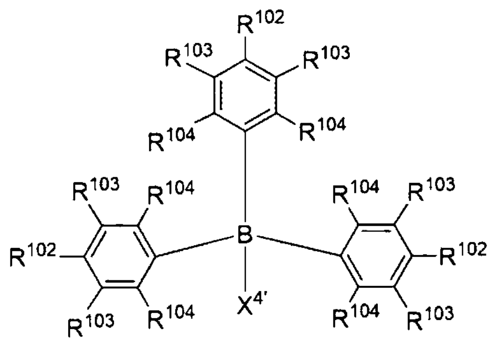

in Chemical Formula 4-1,

$R^{102}$, $R^{103}$, and $R^{104}$ are each independently hydrogen, methyl, methoxy, halogen, phenyl, or vinyl, and
$X^{4'}$ is a straight chain alkyl group having 1 to 12 carbon atoms,

[Chemical Formula 4-2]

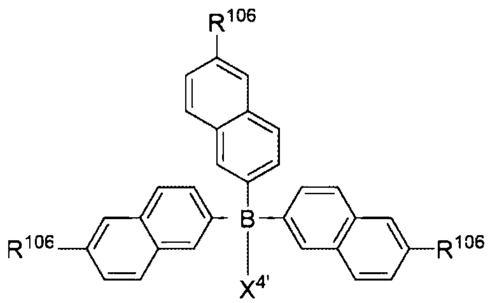

in Chemical Formula 4-2,

each $R^{106}$ is independently hydrogen, methyl, methoxy, halogen, or vinyl, and
$X^{4"}$ is a straight chain alkyl group having 1 to 12 carbon atoms.

**9.** The photopolymer composition according to claim 1, wherein further comprising a photoinitiator, wherein the photoinitiator comprises a phosphine oxide-based compound.

**10.** The photopolymer composition according to claim 1, wherein further comprising a plasticizer, wherein the plasticizer comprises at least one selected from the group consisting of fluorinated compounds represented by the following Chemical Formulas 5-1 to 5-3:

[Chemical Formula 5-1]

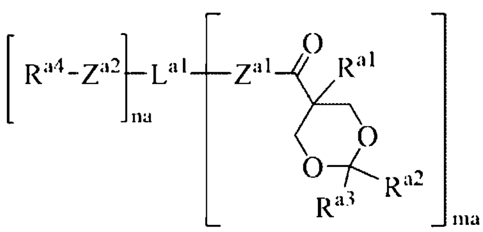

In Chemical Formula 5-1,

$Z^{a1}$ is -O- or -NH-,
$Z^{a2}$ is a single bond, -O-, or -NH-,
$L^{a1}$ is a single bond or a divalent to hexavalent organic group in which hydroxy groups have been removed from a polyol having 2 to 6 hydroxyl groups,
na and ma are each independently an integer of 1 to 5, wherein the sum of na and ma is 2 to 6,
$R^{a1}$, $R^{a2}$, and $R^{a3}$ are each independently methyl or ethyl,
$R^{a4}$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines,

[Chemical Formula 5-2]

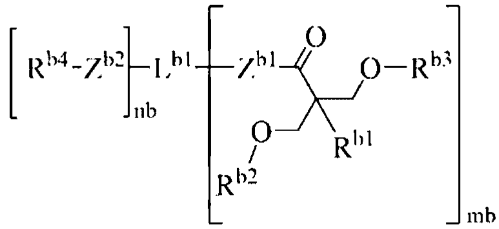

in Chemical Formula 5-2,

$Z^{b1}$ is -O- or -NH-,
$Z^{b2}$ is a single bond, -O- or -NH-,
$L^{b1}$ is a single bond or a divalent to hexavalent organic group in which hydroxy groups have been removed from a polyol having 2 to 6 hydroxyl groups,
nb and mb are each independently an integer of 1 to 5, wherein the sum of nb and mb is 2 to 6,
$R^{b1}$ is a methyl group or an ethyl group, and
at least one of $R^{b2}$ to $R^{b4}$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines,
when $R^{b2}$ and $R^{b3}$ are not fluorine-containing substituents, they are each independently hydrogen, an alkyl group having 1 to 20 carbon atoms, a cycloalkyl group having 3 to 30 carbon atoms, a heterocycloalkyl group having 4 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or are substituents in which at least one $-CH_2-$ of the above substituents is substituted with -O-, -S- or -NH-, and
when $R^{b4}$ is not a fluorine-containing substituent, it is an alkyl group having 2 to 20 carbon atoms, a cycloalkyl group having 3 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or is a substituent in which at least one $-CH_2-$ of the above substituents is substituted with -O-, -S-, or -NH-,

[Chemical Formula 5-3]

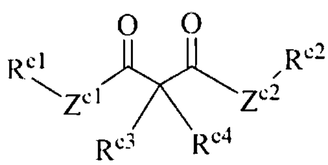

in Chemical Formula 5-3,

$Z^{c1}$ and $Z^{c2}$ are each independently -O-, -S-, or -NH-,
at least one of $R^{c1}$ to $R^{c4}$ is a fluorine-containing substituent, which is an alkyl group having 1 to 20 carbon atoms substituted with 2 or more fluorines, a cycloalkyl group having 3 to 30 carbon atoms substituted with 2 or more fluorines, or an aryl group having 6 to 30 carbon atoms substituted with 2 or more fluorines,

when $R^{c1}$ to $R^{c4}$ are not fluorine-containing substituents, they are each independently an alkyl group having 1 to 20 carbon atoms, a cycloalkyl group having 3 to 30 carbon atoms, a heterocycloalkyl group having 4 to 30 carbon atoms, a cycloalkylalkyl group having 7 to 40 carbon atoms, an aryl group having 6 to 30 carbon atoms, a heteroaryl group having 4 to 30 carbon atoms or an arylalkyl group having 7 to 40 carbon atoms, or are substituents in which at least one $-CH_2-$of the above substituents is substituted with -O-, -S- or -NH-.

**11.** A hologram recording medium comprising a photopolymer layer formed from the photopolymer composition according to claim 1.

**12.** The hologram recording medium according to claim 11, wherein when recording a notch filter hologram, a diffraction efficiency is 70% or more.

**13.** The hologram recording medium according to claim 11, wherein when the hologram recording medium before recording is stored under high temperature of 60°C for 30 days and then a notch filter hologram is recorded, a retention rate of diffraction efficiency is of 90% or more.

**14.** The hologram recording medium according to claim 11, wherein when the hologram recording medium is in an unrecorded state and subjected to photobleaching, the color difference ($\Delta E$) relative to white light of the same brightness is 3.0 or less.

**15.** A method for preparing a hologram recording medium, comprising a step of applying the photopolymer composition according to claim 1 to form a photopolymer layer.

**16.** The method according to claim 15, further comprising a step of recording optical information by irradiating a coherent laser onto a predetermined region of the photopolymer layer and selectively polymerizing the photoreactive monomer contained in the photopolymer layer.

**17.** An optical element comprising the hologram recording medium according to claim 11.

【FIG. 1】

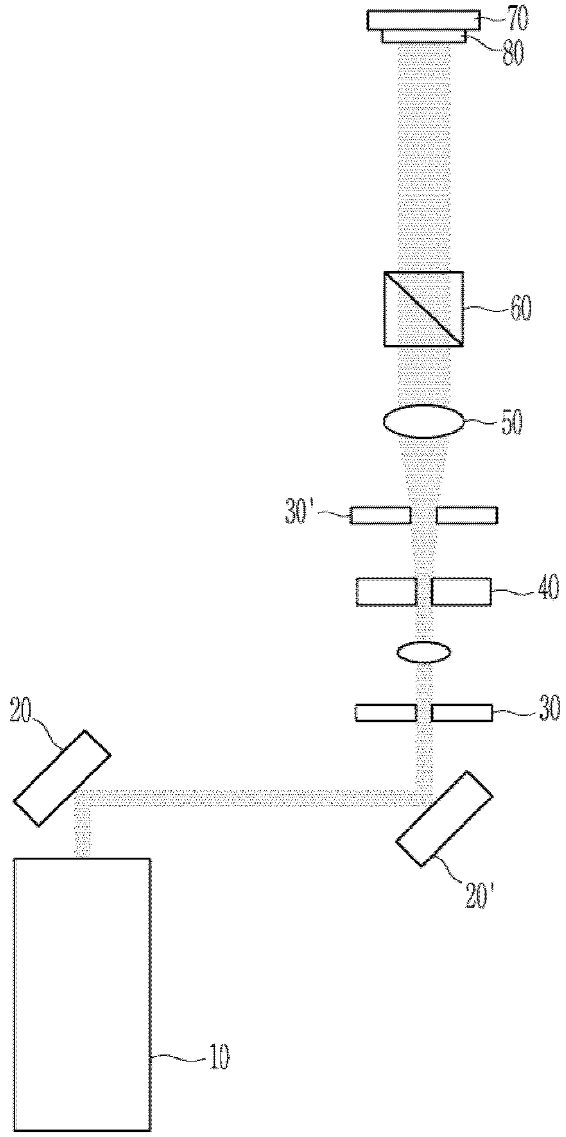

**INTERNATIONAL SEARCH REPORT**

International application No. **PCT/KR2025/002235**

**A. CLASSIFICATION OF SUBJECT MATTER**

**G03F 7/075**(2006.01)i; **C08F 287/00**(2006.01)i; **C08F 2/44**(2006.01)i; **C08F 2/50**(2006.01)i; **C08G 77/42**(2006.01)i; **C08G 77/38**(2006.01)i; **C08G 77/12**(2006.01)i; **C08K 5/3417**(2006.01)i; **C08K 5/55**(2006.01)i; **G03F 7/105**(2006.01)i

According to International Patent Classification (IPC) or to both national classification and IPC

**B. FIELDS SEARCHED**

Minimum documentation searched (classification system followed by classification symbols)

G03F 7/075(2006.01); B41N 1/14(2006.01); C08F 2/44(2006.01); C08F 283/12(2006.01); C09B 11/00(2006.01); G03C 5/26(2006.01); G03F 7/029(2006.01); G11B 7/24(2006.01); G11B 7/24044(2013.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 고분자 매트릭스(polymer matrix), 광반응성 단량체(photo-polymerizable monomer), 염료(dye), 오픈니스(openness), 홀로그램(hologram), 기록매체(recording medium)

**C. DOCUMENTS CONSIDERED TO BE RELEVANT**

| Category* | Citation of document, with indication, where appropriate, of the relevant passages | Relevant to claim No. |
|---|---|---|
| A | KR 10-2013-0126611 A (BAYER INTELLECTUAL PROPERTY GMBH) 20 November 2013 (2013-11-20)<br>See claims 1-9, 12 and 14-17; and paragraphs [1140]-[1143], [1312]-[1334] and [1371]-[1379]. | 1-17 |
| A | KR 10-2021-0003510 A (LG CHEM, LTD.) 12 January 2021 (2021-01-12)<br>See claims 1-16; and paragraphs [0075]-[0084] and [0086]-[0088]. | 1-17 |
| A | KR 10-2018-0020162 A (COVESTRO DEUTSCHLAND AG) 27 February 2018 (2018-02-27)<br>See claims 1-16. | 1-17 |
| A | KR 10-0132430 B1 (HOECHST AKTIENGESELLSCHAFT) 14 April 1998 (1998-04-14)<br>See claims 1-13. | 1-17 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **19 May 2025** | **19 May 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT

International application No.
**PCT/KR2025/002235**

C. DOCUMENTS CONSIDERED TO BE RELEVANT

| Category* | Citation of document, with indication, where appropriate, of the relevant passages | Relevant to claim No. |
|---|---|---|
| A | JP 2000-171974 A (FUJI PHOTO FILM CO., LTD.) 23 June 2000 (2000-06-23)<br>See entire document. | 1-17 |

Form PCT/ISA/210 (second sheet) (July 2022)

**INTERNATIONAL SEARCH REPORT**
**Information on patent family members**

International application No.
**PCT/KR2025/002235**

| Patent document cited in search report | Publication date (day/month/year) | Patent family member(s) | Publication date (day/month/year) |
|---|---|---|---|
| KR 10-2013-0126611 A | 20 November 2013 | CN 103222000 A | 24 July 2013 |
| | | CN 103222000 B | 10 August 2016 |
| | | EP 2450893 A1 | 09 May 2012 |
| | | EP 2638544 A2 | 18 September 2013 |
| | | EP 2638544 B1 | 26 December 2018 |
| | | ES 2717635 T3 | 24 June 2019 |
| | | JP 2013-543149 A | 28 November 2013 |
| | | JP 6144625 B2 | 07 June 2017 |
| | | KR 10-1804608 B1 | 04 December 2017 |
| | | PL 2638544 T3 | 31 July 2019 |
| | | TR 201904304 T4 | 21 May 2019 |
| | | TW 201237119 A | 16 September 2012 |
| | | TW 201631052 A | 01 September 2016 |
| | | TW I593761 B | 01 August 2017 |
| | | TW I612105 B | 21 January 2018 |
| | | US 2013-0224634 A1 | 29 August 2013 |
| | | US 2016-0054704 A1 | 25 February 2016 |
| | | US 9146456 B2 | 29 September 2015 |
| | | US 9760060 B2 | 12 September 2017 |
| | | WO 2012-062655 A2 | 18 May 2012 |
| | | WO 2012-062655 A3 | 07 September 2012 |
| KR 10-2021-0003510 A | 12 January 2021 | CN 112639617 A | 09 April 2021 |
| | | CN 112639617 B | 23 August 2024 |
| | | EP 3838937 A1 | 23 June 2021 |
| | | EP 3838937 B1 | 14 September 2022 |
| | | JP 2021-536039 A | 23 December 2021 |
| | | JP 7130306 B2 | 05 September 2022 |
| | | KR 10-2384288 B1 | 06 April 2022 |
| | | US 11851515 B2 | 26 December 2023 |
| | | US 2021-0340302 A1 | 04 November 2021 |
| | | WO 2021-002648 A1 | 07 January 2021 |
| KR 10-2018-0020162 A | 27 February 2018 | CN 107743595 A | 27 February 2018 |
| | | EP 3314607 A1 | 02 May 2018 |
| | | JP 2018-526475 A | 13 September 2018 |
| | | TW 201710405 A | 16 March 2017 |
| | | US 2018-0223100 A1 | 09 August 2018 |
| | | WO 2016-207155 A1 | 29 December 2016 |
| KR 10-0132430 B1 | 14 April 1998 | DE 3827245 A1 | 15 February 1990 |
| | | EP 0354475 A2 | 14 February 1990 |
| | | EP 0354475 A3 | 20 March 1991 |
| | | EP 0354475 B1 | 15 November 1995 |
| | | JP 02-089055 A | 29 March 1990 |
| | | JP 2840640 B2 | 24 December 1998 |
| | | KR 10-1990-0003685 A | 26 March 1990 |
| | | US 5922508 A | 13 July 1999 |
| JP 2000-171974 A | 23 June 2000 | JP 3905234 B2 | 18 April 2007 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020240022502
- KR 1020240022503
- KR 1020240022504
- KR 1020250019407